# EUROPEAN PATENT APPLICATION

(11) **EP 4 750 306 A1**
(43) Date of publication of application: **27.05.2026**
(21) Application number: 25183220.0
(22) Date of filing: 17.06.2025
(51) Int. Cl.: H10W 20/43, H10D 88/00, H10P 74/00

(54) **SEMICONDUCTOR DEVICE AND SEMICONDUCTOR CHIP COMPRISING THE SAME**

(30) Priority: 20.11.2024 KR 20240165992
(71) Applicant: Samsung Electronics Co., Ltd., Suwon-si, Gyeonggi-do 16677 (KR)
(72) Inventor: SONG, Inhyun, 16677 Suwon-si (KR); KIM, Jongsu, 16677 Suwon-si (KR); CHUNG, Myungjin, 16677 Suwon-si (KR); CHUNG, Eunguk, 16677 Suwon-si (KR); CHO, Keunhwi, 16677 Suwon-si (KR)
(74) Representative: Marks & Clerk LLP

(57) **Abstract**

A semiconductor device includes an active layer including a core region and a dummy region, the active layer including an active region disposed on the core and dummy regions, and gate structures disposed on the active region; a front interconnection layer disposed on the active layer and including a front interconnection structure; and a rear interconnection layer disposed below the active layer and including a rear interconnection structure. The gate structures include first gate structures disposed on the core region and electrically connected to the front interconnection structure, and dummy gate structures disposed on the dummy region and electrically floated. The front interconnection structure includes a first front transmission line disposed on the core region, and a first front connection line disposed on the dummy region. The first front connection line is electrically connected to the first front transmission line and extends from the core region to the dummy region.

## Description

### TECHNICAL FIELD

The present invention relates to a semiconductor device. We further disclose a semiconductor chip comprising the same.

### BACKGROUND

With an increase in demand for high performance, high speed, and/or multifunctionality of semiconductor devices, the integration of semiconductor devices has increased. In accordance with the trend toward high integration of semiconductor devices, semiconductor devices having a BackSide Power Delivery Network (BSPDN) structure in which a power rail is disposed on a backside of a wafer have been developed. Additionally, research has been conducted on structures and methods for Failure Analysis (FA) of semiconductor devices having the BSPDN structure.

### SUMMARY

The present invention is defined by claim 1. Preferred embodiments are defined by the dependent claims. Advantageously, some embodiments of a semiconductor device may improve reliability, preferably without deteriorating electrical characteristics, and a semiconductor chip including the same may be provided in embodiments.

According to an aspect of the present disclosure, a semiconductor device includes: an active layer including a core region, and a dummy region surrounding the core region, the active layer including an active region extending in a first direction and disposed on both the core region and the dummy region, a plurality of gate structures disposed on the active region, each gate structure of the plurality of gate structures extending in a second direction and intersecting the active region, and a plurality of source/drain regions disposed on side surfaces of the plurality of gate structures and disposed on the active region; a front interconnection layer disposed on the active layer and including a front interconnection structure and a front insulating layer covering the front interconnection structure; and a rear interconnection layer disposed below the active layer and including a rear interconnection structure and a rear insulating layer covering the rear interconnection structure. The plurality of gate structures include a plurality of first gate structures disposed on the core region and electrically connected to the front interconnection structure, and a plurality of dummy gate structures disposed on the dummy region and electrically floated. The front interconnection structure includes a first front transmission line disposed on the core region, and a first front connection line disposed on the dummy region. The first front connection line is electrically connected to the first front transmission line and extends from the core region to the dummy region.

According to an aspect of the present disclosure, a semiconductor device includes an active layer including a core region, and a dummy region surrounding the core region; a plurality of transmission lines stacked on the core region in a vertical direction perpendicular to an upper surface of the active layer, the plurality of transmission lines including a plurality of first transmission lines extending in a first horizontal direction parallel to the upper surface of the active layer and a plurality of second transmission lines alternately stacked with the plurality of first transmission lines and extending in a second horizontal direction parallel to the upper surface of the active layer and intersecting the first horizontal direction; a plurality of inspection lines stacked on the dummy region in the vertical direction, the plurality of inspection lines including a plurality of first inspection lines extending in the first horizontal direction and a plurality of second inspection lines alternately stacked with the plurality of first inspection lines and extending in the second horizontal direction; and a plurality of connection lines extending from the core region to the dummy region and electrically connecting the plurality of transmission lines to the plurality of inspection lines. The plurality of connection lines include a plurality of first connection lines extending in the first horizontal direction and a plurality of second connection lines extending in the second horizontal direction.

According to an aspect of the present disclosure, a semiconductor device includes a plurality of gate structures spaced apart from each other in a first direction and each gate structure of the plurality of gate structures extending in a second direction, intersecting the first direction; a plurality of dummy gate structures spaced apart from each other in the first direction and each dummy gate structure of the plurality of dummy gate structures extending in the second direction; an interlayer insulating layer covering the plurality of gate structures and the plurality of dummy gate structures; a front interconnection structure disposed on the interlayer insulating layer; a plurality of gate contacts penetrating through the interlayer insulating layer to electrically connect the plurality of gate structures to the front interconnection structure; and a rear interconnection structure disposed below the plurality of gate structures. The front interconnection structure includes a plurality of front transmission lines, each front line transmission line of the plurality of front transmission lines including a portion overlapping the plurality of gate structures in a third direction perpendicular to the first direction and the second direction; a plurality of front inspection lines, each front inspection line of the plurality of front inspection lines including a portion overlapping the plurality of dummy gate structures in the third direction; and a plurality of front connection lines connecting the plurality of front transmission lines to the plurality of front inspection lines. Each front connection line of the plurality of front connection lines includes a portion overlapping the plurality of gate structures and a portion overlapping the plurality of dummy gate structures in the third direction. The front interconnection structure is electrically isolated from the plurality of dummy gate structures.

In a semiconductor device embodiment having a BSPDN structure, a portion of a metal interconnection in the core region may extend to a dummy region to enable Failure Analysis (FA), and a structure in which the extending metal interconnection is cut after the Failure Analysis (FA). Such an embodimentmay provide a semiconductor device which may improve reliability, preferably without deteriorating electrical characteristics and a semiconductor chip including the same.

Advantages and effects of embodiments are not defined or limited to the foregoing content and may be more easily understood in the process of describing a specific example embodiment of the present invention.

### BRIEF DESCRIPTION OF DRAWINGS

The above and other aspects, features, and advantages of embodiments will be more clearly understood from the following detailed description, taken in conjunction with the accompanying drawings, in which:
FIG. 1 is a schematic plan view illustrating a semiconductor chip according to example embodiments;
FIG. 2A is a schematic plan view illustrating a semiconductor device according to example embodiments;
FIG. 2B is a schematic cross-sectional view illustrating a semiconductor device according to example embodiments;
FIG. 2C is a schematic partial enlarged view illustrating a semiconductor device according to example embodiments;
FIG. 3A is a schematic plan view illustrating a semiconductor device according to example embodiments;
FIG. 3B is a schematic cross-sectional view illustrating a semiconductor device according to example embodiments;
FIGS. 4 to 12 are cross-sectional views illustrating a semiconductor device according to example embodiments;
FIGS. 13A, 14A, 15A, 16A, 17A, 18A, 19A, 20, 21, 22A, 23 and 24 are cross-sectional views illustrating a method of manufacturing a semiconductor device according to an example embodiment of the present disclosure; and
FIGS. 13B, 14B, 15B, 16B, 17B, 18B, 19B and 22B are partially enlarged views illustrating a method of manufacturing a semiconductor device according to example embodiments of the present disclosure.

### DETAILED DESCRIPTION

Hereinafter, example embodiments of the present disclosure will be described with reference to the accompanying drawings. Hereinafter, it may be understood that the expressions such as "on," "above," "upper," "below", "beneath," "lower," and "side," merely indicated based on drawings unless otherwise stated. Furthermore, the symbol "/"between related words generally means "and/or". For example, "source/drain regions" means "source region(s) and/or drain region(s)" whereas "source/drain region" means a region configured to function as either a source region or a drain region. Similarly, "input/output (I/O) pads" means "input pad(s) and/or output pad(s)".

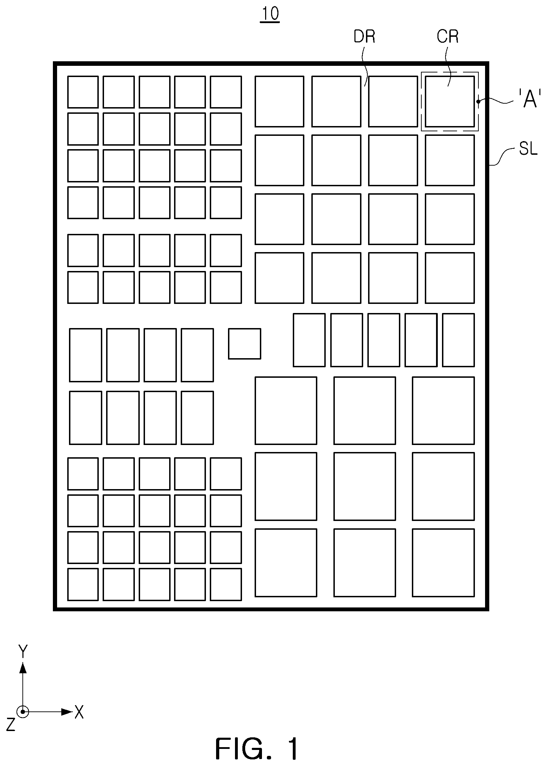

FIG. 1 is a schematic plan view illustrating a semiconductor chip according to example embodiments. For convenience of description, only some components of the semiconductor chip are illustrated in FIG. 1.

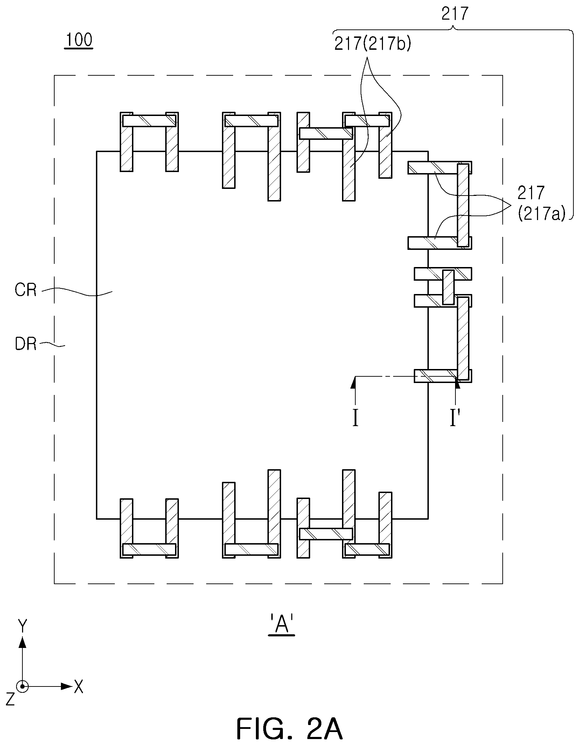

FIG. 2A is a schematic plan view illustrating a semiconductor device according to example embodiments. FIG. 2A illustrates an enlarged view of region 'A' of FIG. 1 and illustrates a semiconductor device disposed in a corresponding region. For convenience of description, FIG. 2A illustrates only some components of the semiconductor device. FIG. 2A illustrates a portion of an interconnection layer, among components that may be included in the semiconductor device.

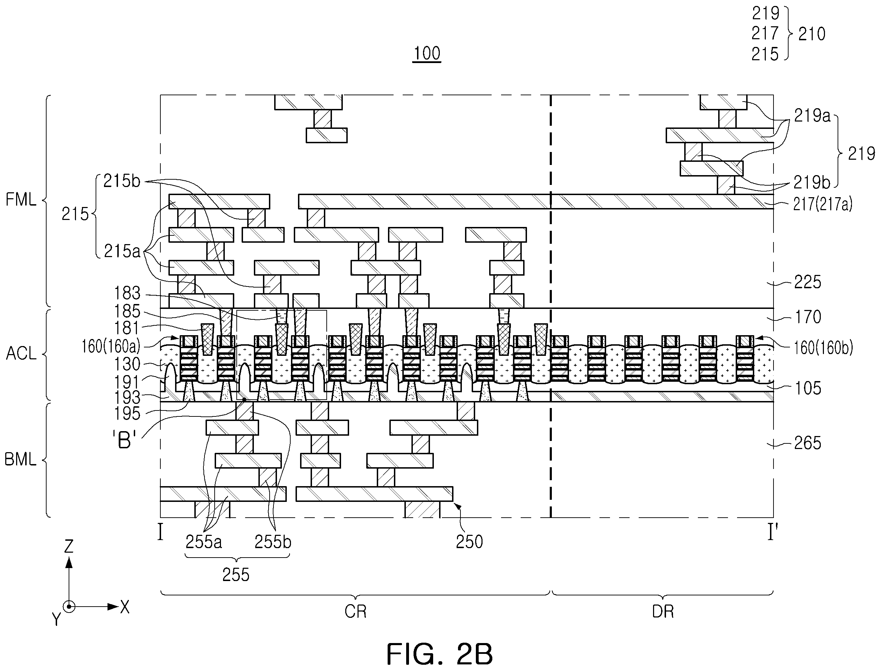

FIG. 2B is a schematic cross-sectional view illustrating a semiconductor device according to example embodiments. FIG. 2B is a schematic cross-sectional view taken along line I-I' of the semiconductor device of FIG. 2A.

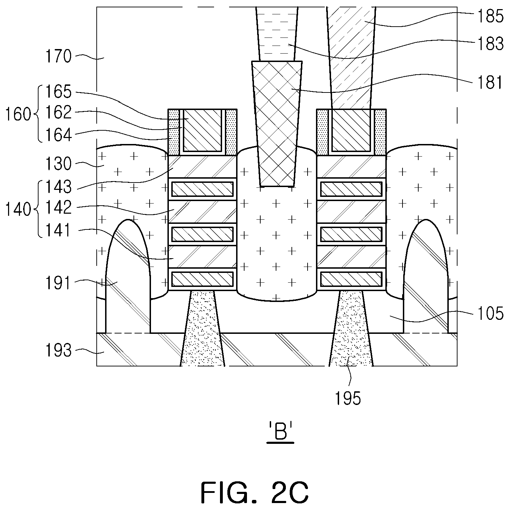

FIG. 2C is a schematic partial enlarged view illustrating a semiconductor device according to example embodiments. FIG. 2C illustrates an enlarged view of region 'B' of FIG. 2B.

Referring to FIG. 1, a semiconductor chip 10 may include a plurality of core regions CR, a dummy region DR surrounding the plurality of core regions, and may further include a residual scribe lane SL surrounding the dummy region DR.

The plurality of core regions CR may be arranged in a grid shape with the same or different sizes, and/or may be regions in which transistors are disposed.

The dummy region DR may surround the plurality of core regions CR and may be disposed between the plurality of core regions CR. The plurality of core regions CR may be separated from each other by the dummy region DR. Within the dummy region DR, components identical to or similar to those disposed in the plurality of core regions CR may be disposed, but such components may be dummy components that do not transmit electrical signals or power. In an embodiment, the dummy components may include dummy transistors with dummy gate structures and dummy source/drain regions. In an embodiment, the core regions CR may refer to the area where functional logic circuits such as processors, memory blocks, signal processors, cache, and/or interconnect fabric are located. For example, the core regions CR may include standard cell logic, custom logic, and/or intellectual property (IP) cores. In an embodiment, the semiconductor chip further includes a peripheral region in which input/output (I/O) pads, a power ring and/or a test circuit are implemented. In an embodiment, the dummy region DR may be disposed in a space between the peripheral region and the core region CR to improve process uniformity in manufacturing the semiconductor chip 10.

The residual scribe lane SL may surround the dummy region DR, and may form an edge of the semiconductor chip 10. The residual scribe lane SL may be a scribe lane remaining after cutting semiconductor chips into individual chip units along the scribe lane in a wafer including semiconductor chips disposed in a grid pattern and scribe lanes extending between the semiconductor chips. Unlike the semiconductor devices that may be disposed in the core region CR and the dummy region DR, the semiconductor devices may not be disposed in the residual scribe lane SL.

Referring to FIGS. 2A to 2C, a semiconductor device 100 includes a core region CR and a dummy region DR surrounding the core region CR, and includes an active layer ACL, a front interconnection layer FML disposed on the active layer ACL and a rear interconnection layer BML disposed below the active layer ACL.

In a structure including the front interconnection layer FML and the rear interconnection layer BML covering an upper portion and a lower portion of the active layer ACL, Failure Analysis (FA) using an optical measurement method of detecting defects in a transistor included in the active layer ACL may be impossible, and thus, defects should for such structures be detected by another method. As one method therefor, a structure of a front interconnection structure 210 of the front interconnection layer FML and a rear interconnection structure 250 of the rear interconnection layer BML may be changed to detect defects in the transistor through Back-End-Of-Line (BEOL) routing which generally refers to the formation of metal interconnects and vias in the BEOL process that electrically connect transistors formed in a Front-End-Of-Line (FEOL) process into functional logic, memory, and/or analog circuits. If necessary, an extending metal line, which is formed by BEOL process, for the detection of defects on the transistors, may be cut to prevent or minimize a decrease in the speed of the semiconductor device. Embodiments may provide a semiconductor device capable of improving reliability preferably without deteriorating the electrical characteristics, for example by enabling a defect detection without deteriorating the performance of the semiconductor device or by minimizing the decrease in performance. The present disclosure may be applied to semiconductor devices included in a peripheral region of a memory chip, such as an SRAM, and/or to semiconductor devices included in a logic chip.

The active layer ACL may include components formed by a Front End Of Line (FEOL) process, for example, a transistor including a gate structure. The front interconnection layer FML may be disposed on the active layer ACL and may include components formed by a rear End Of Line (BEOL) process, and such components may transmit electrical signals to components formed in the active layer ACL. The rear interconnection layer BML may be disposed below the active layer ACL and may include components transmitting power to components formed in the active layer ACL. Each of the active layer ACL, the front interconnection layer FML and the rear interconnection layer BML may include a core region CR and a dummy region DR surrounding the core region. In terms of individual core regions CR, the dummy region DR may be a ring shape surrounding the core region CR. Depending on the description method, the core region CR and the dummy region DR may be defined by the active layer ACL. For example, the core region CR may be a region in which transistors of a semiconductor device are disposed, and/or the dummy region CR may be a region in which dummy transistors are disposed.

The active layer ACL may include preferably all of an active region 105, channel structures 140 including first to third channel layers 141, 142 and/or 143 vertically apart from each other on the active region 105, gate structures 160 extending by intersecting the active region 105 and respectively including a gate electrode 165, source/drain regions 130 connected to the channel structures 140, front side contacts 181 and backside contacts 191 connected to the source/drain regions 130, a lower blocking structure 195 penetrating through the active region 105 below the gate structures 160, and/or a rear power rail 193 connected to the backside contacts 191 below the active region 105. The active layer ACL of the semiconductor device 100 may further include an interlayer insulating layer 170.

In the semiconductor device 100, the active region 105 may have a fin structure. The gate electrode 165 may be disposed between the active region 105 and the channel structure 140, may be disposed between the first to third channel layers 141, 142 and 143 of the channel structure 140, and/or may be disposed on the channel structure 140. Accordingly, the semiconductor device 100 may include transistors having a MBCFET^{™} (Multi Bridge Channel FET) structure, which is a gate-all-around type field effect transistor.

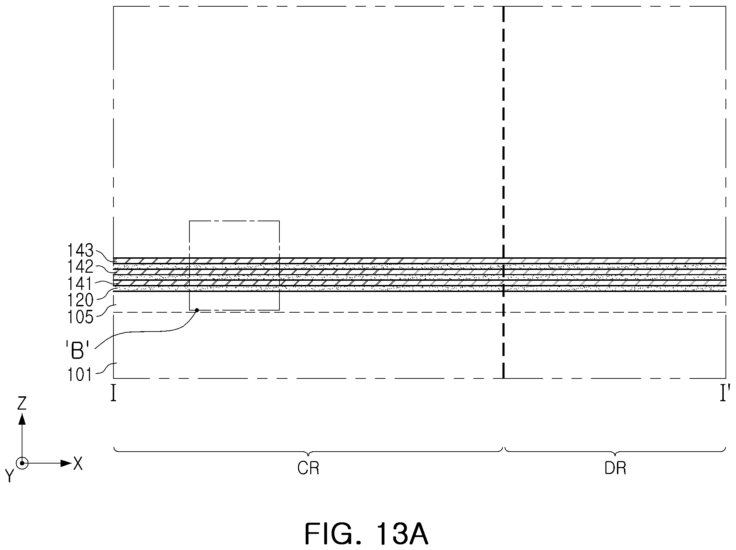

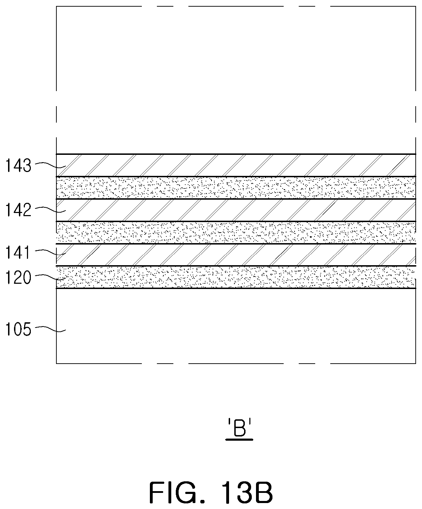

The active region 105 may have an upper surface extending in the first direction (for example, an X-direction). The active region 105 may include a semiconductor material, such as a group IV semiconductor, a group III-V compound semiconductor, and/or a group II-VI compound semiconductor. For example, the group IV semiconductor may include silicon, germanium, or silicon-germanium. Referring to FIGS. 13A and 13B together, the active region 105 may be a component included in a substrate 101 having an upper surface extending in the X-direction and the Y-direction, and as the manufacturing method progresses, at least a portion of the substrate 101 may be removed, so that the active region 105, which is a portion of the substrate 101, may remain in the semiconductor device 100. The substrate 101 may be provided as a bulk wafer, an epitaxial layer, a Silicon On Insulator (SOI) layer, or a Semiconductor On Insulator (SeOI) layer. The substrate 101 may include a semiconductor material, such as a group IV semiconductor, a group III-V compound semiconductor, and/or a group II-VI compound semiconductor. For example, the group IV semiconductor may include silicon, germanium, or silicon-germanium. The active region 105 may be defined by a device isolation layer formed by a shallow trench isolation (STI) process, and may be disposed to extend in one direction, for example, the X-direction. The X-direction may be defined as the first direction or the second direction. The active region 105 may partially protrude onto the device isolation layer, so that an upper surface of the active region 105 may be disposed on a higher level than an upper surface of the device isolation layer. On both sides of the gate structure 160, the active region 105 may be partially recessed to form recessed regions, and source/drain regions 130 may be disposed in the recessed regions.

In example embodiments, the active region 105 may or may not include a well region including impurities. For example, in the case of a P-type transistor (pFET), the well region may include N-type impurities such as phosphorus (P), arsenic (As), and/or antimony (Sb), and in the case of an N-type transistor (nFET), the well region may include P-type impurities such as boron (B), gallium (Ga), and/or indium (In). The well region may be disposed, for example, at a predetermined depth from the upper surface of the active region 105.

The device isolation layer defining the active region 105 may be formed of an insulating material, for example, an oxide, a nitride, or combinations thereof.

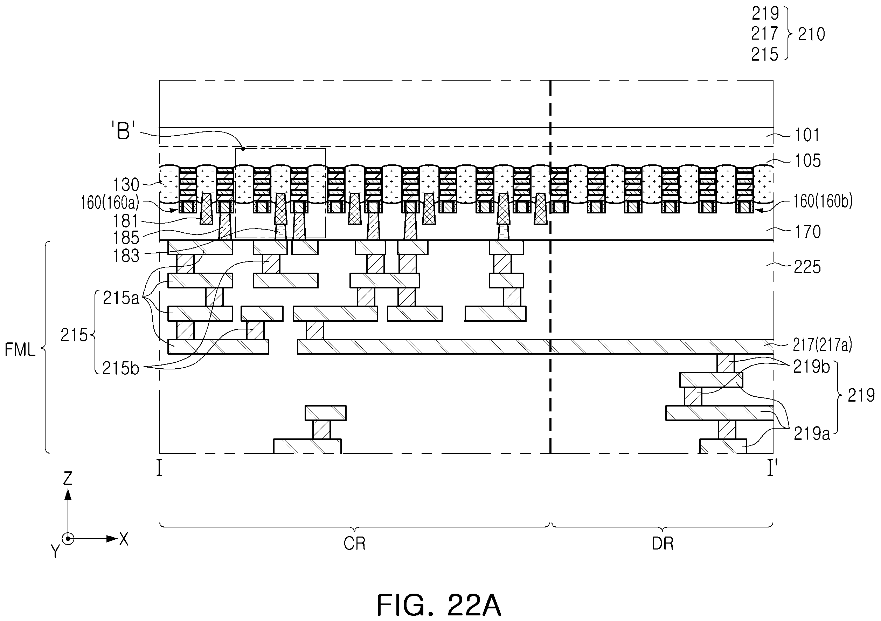

In an example embodiment, the active region 105 may be completely removed during a process and may be replaced with an insulating layer. For example, in FIG. 22A below, not only the substrate 101 but also the active region 105 may be removed, and a space from which the active region 105 is removed may be filled with an insulating material and may be replaced with an insulating layer.

The channel structures 140 may be disposed on the active region 105 in regions in which the active region 105 intersects the gate structures 160. Each of the channel structures 140 may include a plurality of channel layers, such as first to third channel layers 141, 142 and 143, which are spaced apart from each other in a third direction (e.g., Z-direction). The third direction may also be referred to as a vertical direction. The first to third channel layers 141, 142 and 143 may be disposed sequentially from a lower portion of the channel structure 140. The channel structures 140 may be connected to the source/drain regions 130. The channel structures 140 may have a width identical to or similar to the gate structures 160 in the X-direction. The number and shape of the channel layers included in one channel structure 140 may be variously changed in example embodiments. For example, one channel structure 140 may include four channel layers, and may include two or three channel layers or five or more channel layers.

The channel structures 140 may be formed of a semiconductor material, for example, at least one of silicon (Si), silicon germanium (SiGe), and germanium (Ge). The channel structures 140 may be formed of, for example, the same material as the active region 105. In some example embodiments, the channel structures 140 may include an impurity region disposed in a region adjacent to the source/drain regions 130.

The gate structures 160 may be disposed to extend in one direction, for example, the Y-direction, by intersecting the active region 105 and the channel structures 140 on the active region 105 and the channel structures 140. The Y-direction may be defined as the second direction or the first direction. When the active region 105 is defined as extending in the first direction, the gate structures 160 may be defined as extending in the second direction, intersecting the first direction. Conversely, when the gate structures 160 are defined as extending in the first direction, the active region 105 may be defined as extending in the second direction, intersecting the first direction. The first direction and the second direction may also be referred to as a first horizontal direction and a second horizontal direction, respectively. The active region 105 and/or the channel structures 140, intersecting the gate electrodes 165 of the gate structures 160, may form a functional channel region of the transistors.

The gate structures 160 may include first gate structures 160a electrically connected to the front interconnection structure 210 through gate contacts 185 and second gate structures 160b not electrically connected to the front interconnection structure 210. In an embodiment, the second gate structures 160b may be electrically floated dummy gate structures, which are electrically isolated from or left unconnected to other elements including the front interconnection structure 210. The first gate structures 160a may be disposed in the core region CR, and may not be disposed in the dummy region DR. The second gate structures 160b may be disposed in the dummy region DR, and may also be disposed between the first gate structures 160a in the core region CR according to an example embodiment. In an embodiment, some gate structures on the core region CR may appear unconnected to the gate contacts 185, but these gate structures are connected to the gate contacts 185 at different positions along the second direction (Y-axis). Since the gate contacts 185 are not disposed on the second gate structures 160b which are dummy components, an entire upper surface of each of the second gate structures 160b may be covered by the interlayer insulating layer 170. That is, the entire upper surface of each of the second gate structures 160b may be in contact with the interlayer insulating layer 170.

Each of the gate structures 160 may include a gate electrode 165, gate dielectric layer(s) 162, and preferably gate spacer(s) 164.

The gate dielectric layers 162 may be disposed between the active region 105 and the gate electrode 165 and between the channel structure 140 and the gate electrode 165, and may be disposed to cover at least a portion of the surfaces of the gate electrode 165. For example, the gate dielectric layers 162 may be disposed to surround all surfaces excluding an uppermost surface of the gate electrode 165. The gate dielectric layers 162 may extend between the gate electrode 165 and the gate spacers 164, but embodimentsare not limited thereto. The gate dielectric layers 162 may include oxides, nitrides, and/or a high-κ material. The high-κ material may refer to a dielectric material having a higher dielectric constant than a silicon oxide film (SiO₂). The high-κ material may be, for example, one or more of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). According to example embodiments, the gate dielectric layers 162 may be formed of a multilayer film.

The gate electrode 165 may be disposed to fill a gap between channel layers such as the first to third channel layers 141, 142 and 143 on the active region 105 and may extend onto the channel structure 140. The gate electrode 165 may be separated from the first to third channel layers such as 141, 142 and 143 by the gate dielectric layers 162. The gate electrode 165 may include a conductive material, and may include, for example, a metal nitride such as a titanium nitride (TiN), a tantalum nitride (TaN), and/or a tungsten nitride (WN), and/or a metallic material such as aluminum (Al), tungsten (W), and/or molybdenum (Mo), and/or a semiconductor material such as doped polysilicon. According to example embodiments, the gate electrode 165 may be formed of two or more multilayers.

The gate spacers 164 may be disposed on opposite side surfaces, in the first direction (X-axis), of the gate electrode 165 on the channel structure 140. The gate spacers 164 may insulate the source/drain regions 130 from the gate electrode 165. The gate spacers 164 may be formed of a multilayer structure, according to example embodiments. The gate spacers 164 may be formed of at least one of an oxide, a nitride, and an oxynitride, and may be formed of, for example, a low-κ film.

In an example embodiment, a gate capping layer including an insulating material may be disposed on the gate structure 160. The gate capping layer may include, for example, at least one of an oxide, a nitride, and an oxynitride.

The source/drain regions 130 may be disposed in recessed regions obtained by partially recessing an upper portion of the active region 105 on the opposite sides of the gate structure 160. The recessed regions may extend along side surfaces of the channel structures 140 and side surfaces of the gate dielectric layers 162. The source/drain regions 130 may be disposed so as to cover X-directional side surfaces of each of the first to third channel layers 141, 142 and 143 of the channel structures 140. Upper surfaces of the source/drain regions 130 may be disposed at a level equal to or higher than that of lower surfaces of the gate electrodes 165 on the channel structures 140, and the level may be variously changed in example embodiments. In an example embodiment, side surfaces of the source/drain regions 130 may have a curvature according to the first to third channel layers 141, 142 and 143. In an example embodiment, internal spacers including an insulating material may be further disposed between the side surfaces of the source/drain regions 130 and the gate structures 160. A specific shape of the side surfaces of the source/drain regions 130 may be variously changed in example embodiments. The source/drain regions 130 may be epitaxially grown regions, and may include a plurality of epitaxial layers. Epitaxially grown surfaces of the source/drain regions 130 may be in contact with the channel structures 140 and the interlayer insulating layer 170.

The source/drain regions 130 may include a semiconductor material, for example, at least one of silicon (Si) and germanium (Ge), and may further include dopants. For example, for an nFET, the dopants may be an n-type dopant including at least one of phosphorus (P), arsenic (As), and antimony (Sb). For example, for a pFET, the dopants may be a p-type dopant including at least one of boron (B), gallium (Ga), and indium (In).

The interlayer insulating layer 170 may be disposed to cover the source/drain regions 130 and the gate structures 160. In an example embodiment, the interlayer insulating layer 170 may include a plurality of insulating layers. The interlayer insulating layer 170 may include at least one of an oxide, a nitride, and an oxynitride, and may include, for example, a low-κ material.

The front side contacts 181 may be connected to the source/drain regions 130 and may transmit power to the source/drain regions 130. The front side contacts 181 may be disposed to penetrate through the interlayer insulating layer 170 and to recess into or extend into the source/drain region 130 from an upper portion. The front side contacts may have a side surface inclined, toward the active region 105 due to an aspect ratio, that is, so that a width thereof decreases as the level decreases, but embodiments are not limited thereto. The front side contacts 181 may extend below a lower surface of a third channel layer 143 as a first channel layer from an upper portion of the channel structure 140 as shown in this example embodiment of FIG. 2C. Embodiments are not limited thereto. In an embodiment, the front side contacts 181 may extend below a lower surface of a second channel layer 142. Although not specifically illustrated, the front side contacts 181 may include a metal-semiconductor compound layer disposed along a surface in which the source/drain regions 130 is recessed, and a conductive layer on the metal-semiconductor compound layer. The metal-semiconductor compound layer may include a metal element and a semiconductor element, and may include, for example, metal silicide including at least one of TiSi, CoSi, MoSi, LaSi, NiSi, TaSi, and WSi. A conductive layer included in the front side contacts 181 may include, for example, a metallic material such as tungsten (W), cobalt (Co), molybdenum (Mo), copper (Cu), ruthenium (Ru), and/or aluminum (Al).

The backside contacts 191 may be connected to the source/drain regions 130 and may transmit power to the source/drain regions 130. The backside contacts 191 may be disposed to penetrate through the active region 105 and to recess into or extend into the source/drain region 130 from a lower portion. The backside contacts 191 may have a side surface inclined so that a width thereof decreases as the level increases due to the aspect ratio, but embodiments are not limited thereto. The backside contacts 191 may extend above an upper surface of a first channel layer 141 as a first channel layer from a lower portion of the channel structure 140, as shown in this example embodiment of FIG. 2C. Embodiments are not limited thereto. In an embodiment, the backside contacts 191 may extend above the lower surface of the second channel layer 142. Although not specifically illustrated, the backside contacts 191 may include a metal-semiconductor compound layer in which the source/drain regions 130 are disposed along the recessed surface, and may further include a conductive layer below the metal-semiconductor compound layer. The metal-semiconductor compound layer may include a metal element and a semiconductor element, and may include, for example, metal silicide including at least one of TiSi, CoSi, MoSi, LaSi, NiSi, TaSi, and WSi. The conductive layer included in the backside contacts 191 may include, for example, a metallic material such as tungsten (W), cobalt (Co), molybdenum (Mo), copper (Cu), ruthenium (Ru), and/or aluminum (Al).

The rear power rail 193 may be disposed below the backside contacts 191 and electrically connected to the backside contacts 191. In an example embodiment, the rear power rail 193 may be disposed below the active region 105 and extend in the first direction (e.g., the X-direction) in which the active region 105 extends. In an example embodiment, the rear power rail 193 may be formed simultaneously with the backside contacts 191 so that the rear power rail 193 and the backside contacts 191 may be integrally formed. The rear power rail 193 may form a BSPDN that applies a power or ground voltage, together with the backside contacts 191. In an example embodiment, the rear power rail 193 may include a via region and/or a line region. The rear power rail 193 may include a conductive material, and may include, for example, at least one of tungsten (W), copper (Cu), aluminum (Al), cobalt (Co), ruthenium (Ru), titanium (Ti), and molybdenum (Mo).

The lower blocking structures 195 may be disposed below the gate structure 160 and penetrate through the active region 105. The lower blocking structure 195 may separate the active region 105. The lower blocking structures 195 may block leakage current that may occur in the active region 105 below the gate structures 160. The lower blocking structures 195 may be in contact with lower surfaces of the gate structures 160. In an example embodiment, the lower blocking structures 195 may penetrate through the rear power rail 193. In an example embodiment, depending on the design intent, the lower blocking structures 195 may separate the rear power rail 193. The lower blocking structures 195 may have a shape in which a width thereof decreases as the level increases, but embodiments are not limited thereto. For example, in some example embodiments, the lower blocking structures 195 may have a shape in which, as the level increases, a width thereof increases and then decreases again. In the second direction (e.g., the Y-direction), a width of each of the lower blocking structures 195 may be equal to or greater than a width of the active region 105. The lower blocking structures 195 may include an insulating material, and may include, for example, at least one of an oxide, a nitride, and an oxynitride. The lower blocking structures 195 may be disposed within the core region CR and may not be disposed within the dummy region DR. In an example embodiment, when the active region 105 is removed and replaced with an insulating layer, the lower blocking structures 195 may not be disposed.

The gate contacts 185 may be disposed on the gate structures 160 and electrically connected to the gate structures 160. The gate contacts 185 may be disposed on the gate structures 160 by penetrating through the interlayer insulating layer 170. The gate contacts 185 may electrically connect the front interconnection structure 210 of the front interconnection layer FML and the gate structures 160, and may transmit an electrical signal to the gate structures 160. The gate contacts 185 may be disposed on the first gate structures 160a disposed in the core region CR, and may not be disposed on the second gate structures 160b.

Upper vias 183 may be disposed on the front side contacts 181 and electrically connected to the front side contacts 181. The upper vias 183 may electrically connect the front interconnection structure 210 of the front interconnection layer FML to the front side contacts 181 and may transmit power to the source/drain regions 130. The upper vias 183 may not be disposed within the dummy region DR.

The front interconnection layer FML may include components formed by BEOL process, for example, the front interconnection structure 210 and a front insulating layer 225 covering the front interconnection structure 210.

The front interconnection structure 210 may be disposed within the front interconnection layer FML on the active layer ACL, and may include front transmission lines 215 sequentially stacked within the core region CR and front connection lines 217 connected to the front transmission lines 215 and extending from the core region CR to the dummy region DR.

Although not specifically illustrated, vias may be disposed between lines disposed on different levels, and lines disposed on different levels may be connected to each other through the vias disposed therebetween.

The front transmission lines 215 may include first front transmission lines 215a extending in the first direction, for example, in the X-direction, and may include second front transmission lines 215b alternately stacked with the first front transmission lines 215a and extending in the second direction, for example, in the Y-direction. A line disposed on a lowest level among the front transmission lines 215 and connected to the upper vias 183 or the gate contacts 185 in the active layer ACL may be the first front transmission line 215a extending in the first direction. Each of the front transmission lines 215 may be a power transmission line or a signal transmission line. The power transmission lines may supply different power voltages (e.g., VDD and VSS) to the semiconductor devices, and may be electrically connected to the source/drain regions 130 within the active layer ACL. The signal transmission lines may supply an electrical signal to the semiconductor device, and may be electrically connected to the gate structures 160. The front transmission lines 215 may be disposed in the core region CR and may not be disposed in the dummy region DR. The front transmission lines 215 may be electrically connected to the first gate structures 160a and/or the source/drain regions 130 disposed within the core region CR of the active layer ACL, but may not be electrically connected to the second gate structures 160b and/or the source/drain regions 130 disposed within the dummy region DR of the active layer ACL, and may be electrically isolated from the second gate structures 160b and/or the source/drain regions 130 disposed in the dummy region DR.

The front connection lines 217 may extend from the front transmission lines 215 within the core region CR and may extend into the dummy region DR. The front connection lines 217 may include first front connection lines 217a extending in the first direction, for example, in the X-direction, and/or second front connection lines 217b extending in the second direction, for example, in the Y-direction. In an embodiment, the first front connection lines 217a may be disposed at the same level as the first front transmission lines 215a. For example, the first front connection line 217a may be disposed at the same level as the uppermost first front transmission line 215a. In an embodiment, the second front connection lines 217b may be disposed at the same level as the second front transmission lines 215b.

Front inspection lines 219 may be disposed within the dummy region DR, and/or may be electrically connected to the front transmission lines 215 via the front connection lines 217. The front inspection lines 219 may include first front inspection lines 219a extending in the first direction, for example, in the X-direction, and/or second front inspection lines 219b extending in the second direction, for example, in the Y-direction. The first front inspection lines 219a may be disposed at the same level as the first front transmission lines 215a, and/or the second front inspection lines 219b may be disposed at the same level as the second front transmission lines 215b. In an example embodiment, the first front inspection lines 219a and the second front inspection lines 219b may be alternately stacked and prefearbly extended so that the front inspection lines 219 extend to an upper surface of the front interconnection layer FML. For example, the front interconnection layer FML may be multi-levels including the first front transmission lines 215a and the second front transmission lines 215b which are alternately stacked in the vertical direction, and the front inspection lines 219 may likewise be formed in multi-levels, with each level of the front inspection lines 219 preferably corresponding to and aligned with a respective level of the front interconnection layer FML.

The front interconnection structure 210 may include a conductive material, for example, at least one of aluminum (Al), copper (Cu), tungsten (W), and ruthenium (Ru).

The front insulating layer 225 may cover the front interconnection structure 210 and may include a plurality of insulating layers. For example, the front insulating layer 225 may include a plurality of insulating layers stacked and disposed at levels corresponding to the respective levels of the front interconnection structure 210. The front insulating layer 225 may include an insulating material, and may include, for example, oxide, nitride, and/or oxynitride.

By performing a routing test on the front inspection lines 219 disposed in the dummy region DR, defect detection may be performed on at least components disposed near an edge (i.e., an outer boundary) of the core region CR. According to an example embodiment, defect detection may also be performed on the components disposed inside the core region CR. The front inspection lines 219 may be connected to the front transmission lines 215 through the front connection lines 217, and the front inspection lines 219 may be disposed in a dummy region DR in which the front transmission lines 215 are not disposed. In some embodiments this may allow defects to be detected in the components in the active layer ACL preferably without changing an arrangement of the front transmission lines 215 in the core region CR. Additionally or alternatively, because the interconnection line is extended only to e.g. the minimum preferred or necessary for routing tests, performance degradation of the semiconductor device due to increased interconnect length can be minimized, in some embodiments thereby enabling improved electrical characteristics. In an embodiment, the routing test may include scan chain testing to detect logical and/or memory cell failures, IDDQ testing to measure abnormal static current to detect leakage paths or shorts, and/or parametric testing to measure electrical characteristics of transistors.

The rear interconnection layer BML may include the rear interconnection structure 250 applying power to the rear power rail 193 and the backside contacts 191, and may include a rear insulating layer 265 covering the rear interconnection structure 250.

Although not specifically illustrated, vias may be disposed between lines disposed on different levels, and lines disposed on different levels may be connected to each other through vias disposed therebetween. For example, vias may be disposed in a space between preferably adjacent ones of the first front transmission lines 215a and the second front transmission lines 215b, thereby in embodiments connecting a first front transmission line 215a to a second front transmission line 215b. Similarly, vias may be disposed in a space between adjacents ones of the first front inspection lines 219a and the second front inspection lines 219b, thereby in embodiments connecting a first front inspection line 219a to a second front inspection line 219b.

The rear interconnection structure 250 may include first rear transmission lines 255a extending in the first direction, for example, the X-direction, and may include second rear transmission lines 255b alternately stacked with the first rear transmission lines 255a and extending in the second direction, for example, the Y-direction. Although not specifically illustrated, the first rear transmission lines 255a and the second rear transmission lines 255b disposed on different levels may be connected through rear vias disposed therebetween. The rear transmission lines 255 may be electrically connected to the source/drain regions 130 in the active layer ACL and may supply different power voltages (e.g., VDD and VSS) to the source/drain regions 130, respectively. The rear transmission lines 255 may be disposed in the core region CR, and/or may not be disposed in the dummy region DR. The rear transmission lines 255 may be electrically connected to the source/drain regions 130 in the core region CR, and/or may not be electrically connected to the source/drain regions 130 in the dummy region DR.

The rear insulating layer 265 may cover the rear interconnection structure 250 and/or may include a plurality of insulating layers. For example, the rear insulating layer 265 may include the plurality of insulating layers stacked and disposed at levels corresponding to the respective levels of the rear interconnection structure 250. The rear insulating layer 265 may include an insulating material, for example, an oxide, a nitride, and/or an oxynitride.

The semiconductor device 100 may be packaged by inverting the structure of FIG. 2B upside down so that the rear interconnection layer BML is disposed in an upper portion, but a packaging form of the semiconductor device 100 is not limited thereto.

In the description of the example embodiments below, descriptions overlapping the description described above with reference to FIG. 1 and FIG. 2A to FIG. 2C will be omitted.

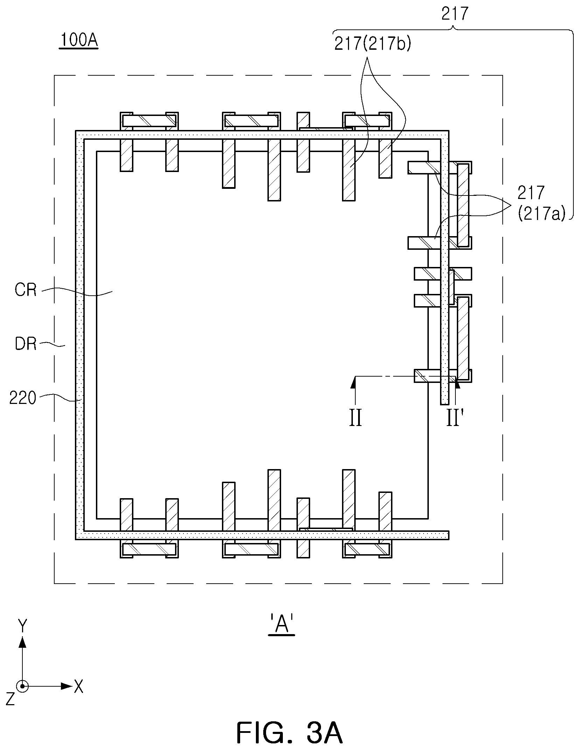

FIG. 3A is a schematic plan view illustrating a semiconductor device according to example embodiments. FIG. 3A illustrates a region corresponding to FIG. 2A. For convenience of description, FIG. 3A illustrates only some components of the semiconductor device. FIG. 3A illustrates a portion of the interconnection layer and a front separation structure 220, among the components that may be included in the semiconductor device.

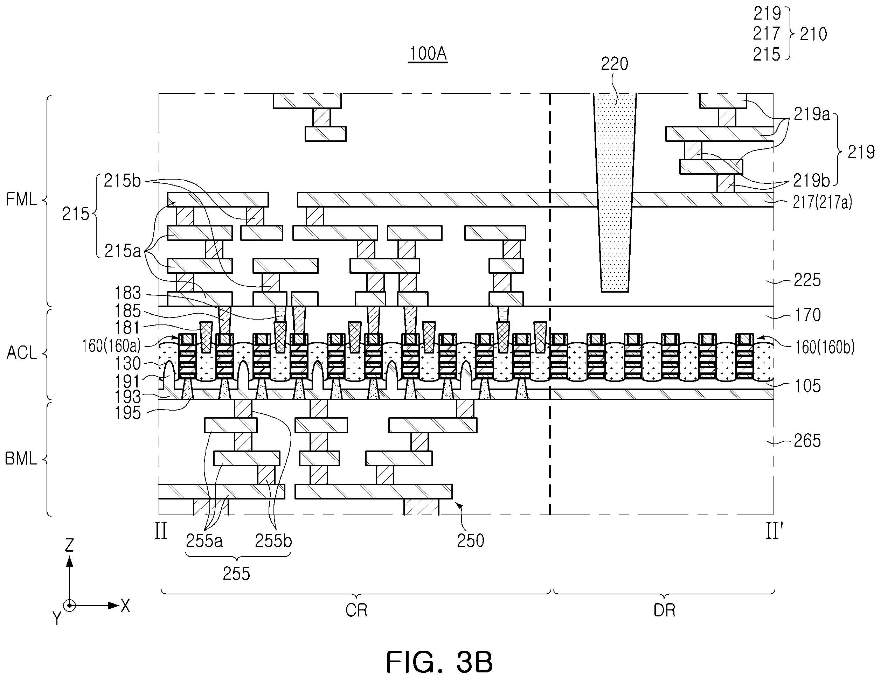

FIG. 3B is a schematic cross-sectional view illustrating a semiconductor device according to example embodiments. FIG. 3B schematically illustrates a cross-section taken along a cutting line II - II' of the semiconductor device of FIG. 3A.

Referring to FIGS. 3A and 3B, unlike the semiconductor device 100 of FIGS. 2A to 2C, a semiconductor device 100A may further include a front separation structure 220. The front separation structure 220 may penetrate through the front connection lines 217 within the front interconnection layer FML and may separate the front connection lines 217 from each other. Accordingly, the front transmission lines 215 within the core region CR and the front inspection lines 219 within the dummy region DR may be electrically isolated from each other. For example, the front separation structure 220 may cut each of the front connection lines 217 into two portions. One of the two portions may be still connected to the front transmission lines 215 of the core region CR, and the other portion may be disconnected from the front transmission lines 215. The front separation structure 220 may extend in a vertical direction (e.g., in the Z-direction) within the front interconnection layer FML. A lower end of the front separation structure 220 may be disposed within the front interconnection layer FML, and the front separation structure 220 may be spaced apart from the active layer ACL. The front separation structure 220 may be disposed in the dummy region DR and may extend to surround at least a portion of an edge (i.e., an outer boundary) of the core region CR, may penetrate through all of the front connection lines 217 and/or may separate the front connection lines 217 from each other. In an example embodiment, the front separation structure 220 may not be disposed in a portion in which the front connection lines 217 are not disposed, and/or may not surround a portion of the edge of the core region CR.

The semiconductor device 100A may form the front separation structure 220 obtained by cutting and separating the front connection lines 217 after utilizing the front connection lines 217 and the front inspection lines 219 disposed for defect detection. In some embodiments it may thus be possible to provide a semiconductor device that may prevent the performance of the semiconductor device from being degraded due to an extension of the interconnection line and/or may improve reliability without deteriorating the electrical characteristics.

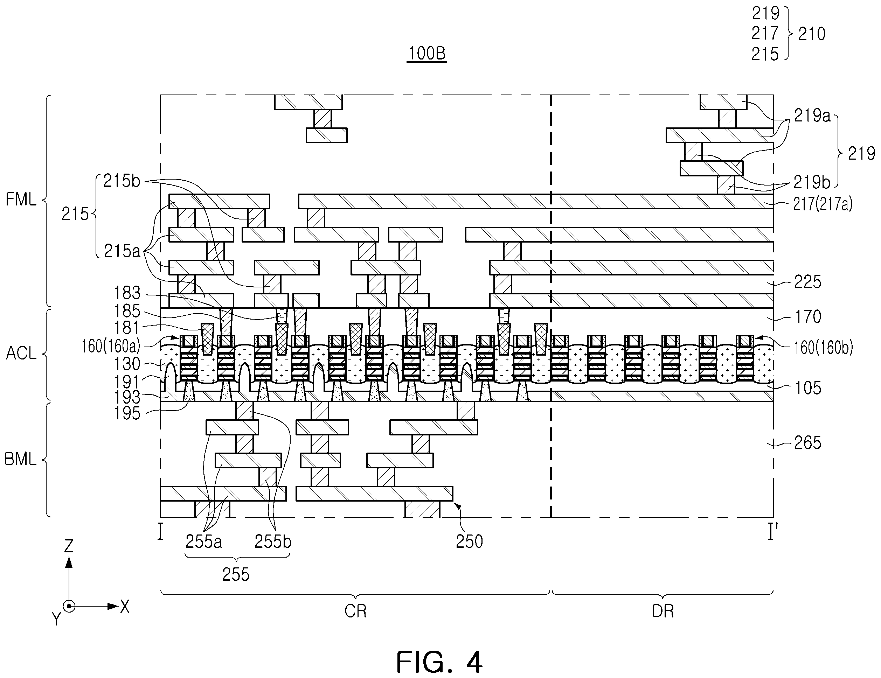

FIGS. 4 to 12 are cross-sectional views illustrating semiconductor devices according to example embodiments. FIGS. 4 to 12 each illustrate a region corresponding to FIG. 2B.

Referring to FIG. 4, unlike the semiconductor device 100 of FIGS. 2A to 2C, a semiconductor device 100B may include front interconnection structures 210 disposed on different levels. The front connection lines 217 may include first front connection lines 217a extending in the first direction and disposed on different levels, and the front inspection lines 219 may be in contact with at least portions of the front connection lines 217 and/or may be connected to the front transmission lines 215.

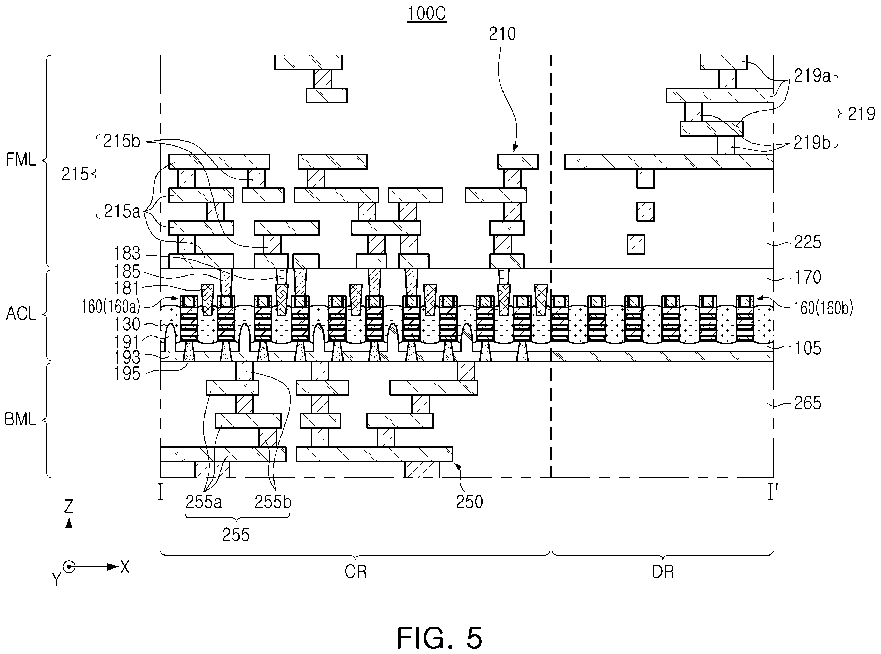

Referring to FIG. 5, unlike the semiconductor device 100B of FIG. 4, a semiconductor device 100C may be configured so that the front transmission lines 215 and the front inspection lines 219 may be spaced apart from each other in the first direction. In this case, referring also to FIG. 2A, the front transmission lines 215 and the front inspection lines 219 may be electrically connected to each other by the first front connection lines 217a extending in the first direction and the second front connection lines 217b extending in the second direction.

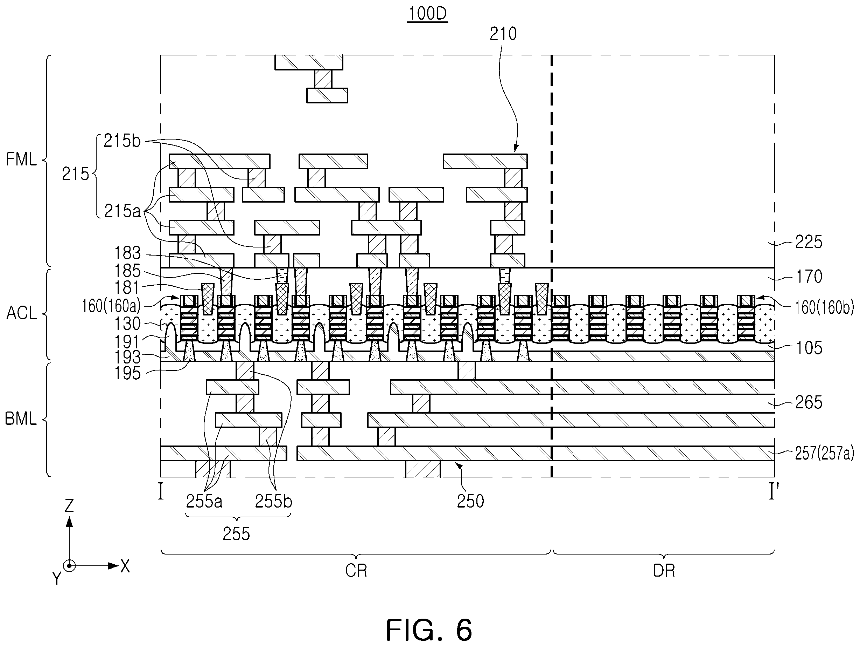

Referring to FIG. 6, unlike the semiconductor device 100 of FIGS. 2A to 2C, a semiconductor device 100D may be configured so that the rear interconnection structure 250 may include rear connection lines 257 extending from the core region CR to the dummy region DR. In an example embodiment, the rear interconnection structure 250 may include first rear connection lines 257a extending in the first direction. The first rear connection lines 257a may include lines disposed on different levels. The front interconnection structure 210 may not include the front connection lines 217 and the front inspection lines 219, unlike the semiconductor device 100 of FIGS. 2A to 2C.

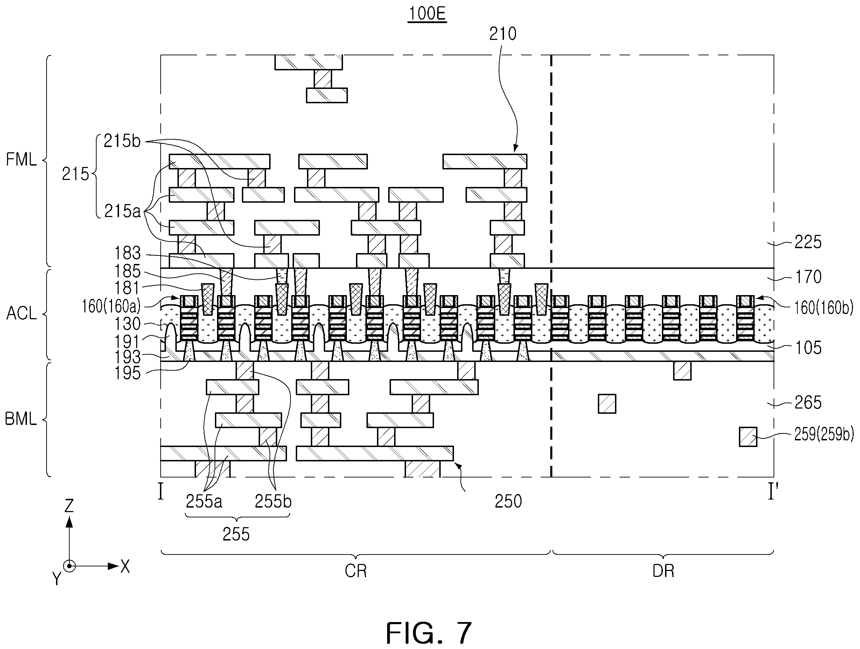

Referring to FIG. 7, a semiconductor device 100E may include rear inspection lines 259 extending from the dummy region DR. Referring also to FIG. 2A, similarly to the semiconductor device 100C of FIG. 5, the rear interconnection structure 250 may include rear connection lines 257 extending in the second direction.

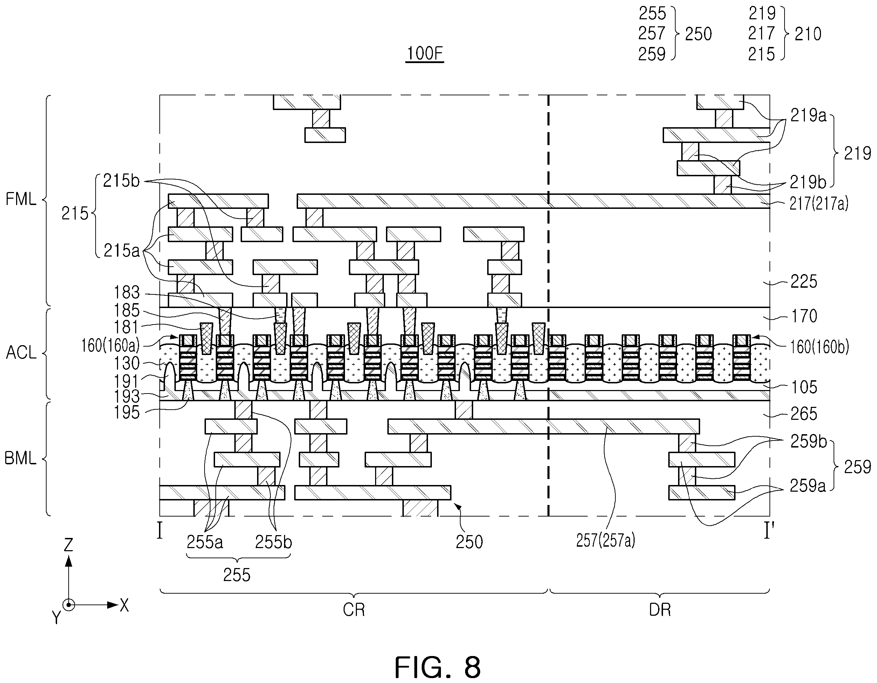

Referring to FIG. 8, unlike the previous example embodiments, a semiconductor device 100F may include both the front connection lines 217 and the rear connection lines 257. The rear interconnection structure 250 may include rear transmission lines 255 disposed within the core region CR, rear connection lines 257 extending from the core region CR into the dummy region DR, and/or rear inspection lines 259 connected to the rear transmission lines 255 through the rear connection lines 257 within the dummy region DR. The front transmission lines 215 and the rear transmission lines 255 may be collectively referred to as 'transmission lines,' the front connection lines 217 and the rear connection lines 257 may be collectively referred to as 'connection lines,' and the front inspection lines 219 and the rear inspection lines 259 may be collectively referred to as 'inspection lines.' The front interconnection structure 210 and the rear interconnection structure 250 may be collectively referred to as 'interconnection structures.' For example, the 'interconnection structure' may be a component referring to the front interconnection structure 210 or the rear interconnection structure 250 according to an example embodiment.

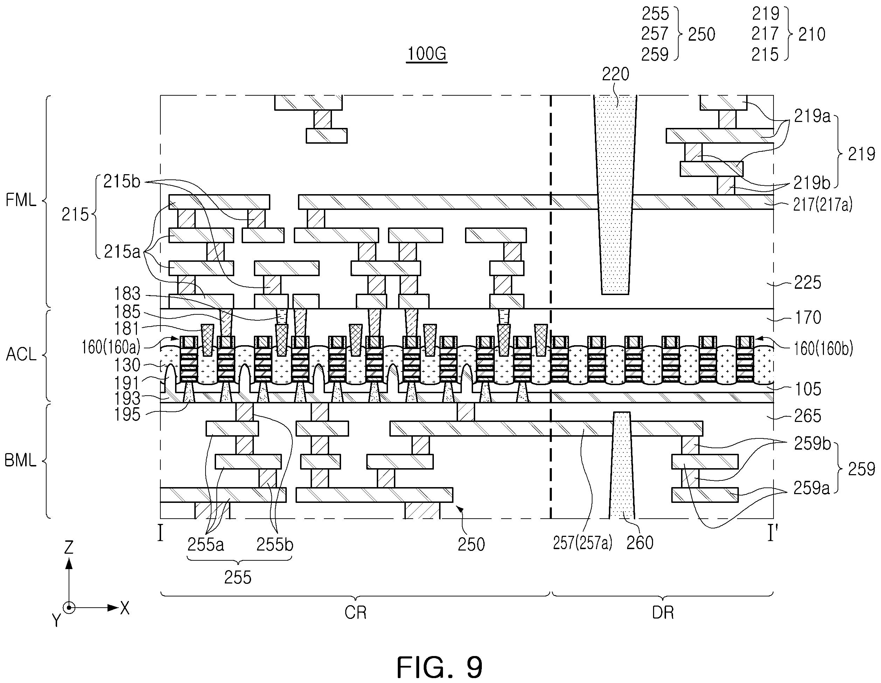

Referring to FIG. 9, unlike the semiconductor device 100F of FIG. 8, a semiconductor device 100G may further include a front separation structure 220 and a rear separation structure 260. The front separation structure 220 may separate the front connection lines 217 within the front interconnection layer FML, and/or the rear separation structure 260 may separate the rear connection lines 257 within the rear interconnection layer BML. The rear separation structure 260 may extend in the vertical direction, and an upper end thereof may be disposed at a level lower than that of the active layer ACL and may be spaced apart from the active layer ACL. In the third direction (e.g., Z-direction), the rear separation structure 260 may include a portion overlapping the front separation structure 220. The rear separation structure 260 may have the features identical to or similar to the front separation structure 220 except for a position in which the components are disposed. For example, the rear separation structure 260 may extend along the edge of the core region CR within the dummy region DR and may surround at least a portion of the edge of the core region CR, similarly to the front separation structure 220 illustrated in FIG. 3A.

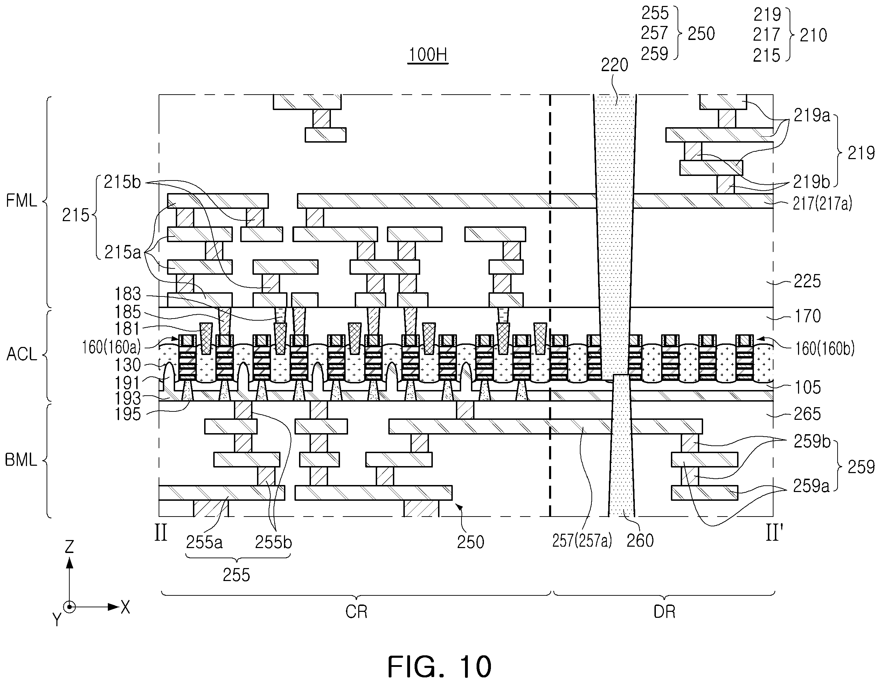

Referring to FIG. 10, unlike the semiconductor device 100G of FIG. 9, a semiconductor device 100H may be configured so that the front separation structure 220 and the rear separation structure 260 may extend into the active layer ACL. The front separation structure 220 and the rear separation structure 260 may be in contact with each other. Advantageously, since the front separation structure 220 and the rear separation structure 260 extend within the dummy region DR, even if the front separation structure 220 and the rear separation structure 260 extend into the active layer ACL, the transistors and other components within the core region CR may not be damaged.

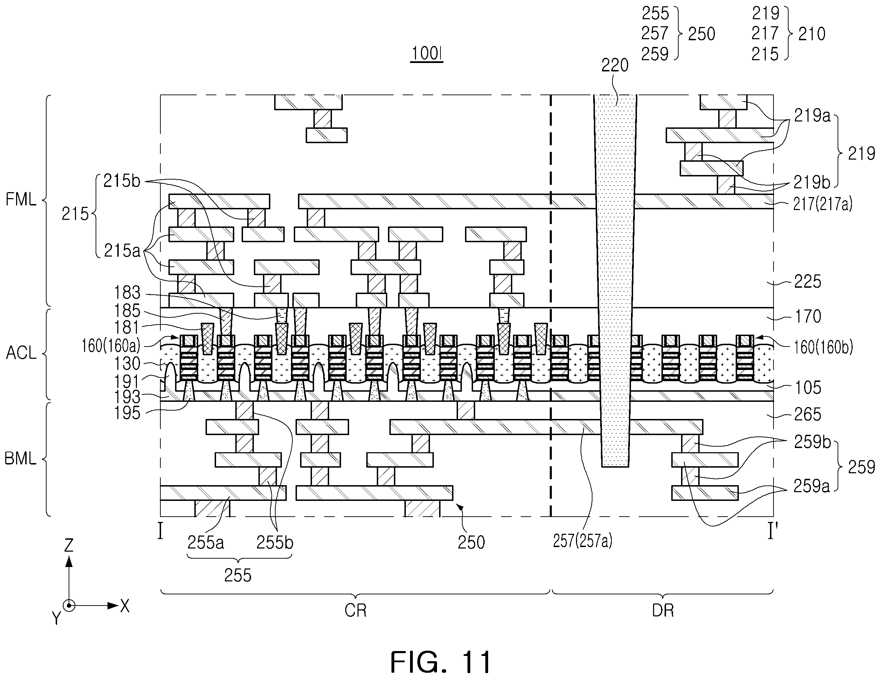

Referring to FIG. 11, unlike the semiconductor device 100G of FIG. 9, a semiconductor device 100 may not include a rear separation structure 260, and may be configured so that the front separation structure 220 may extend through the active layer ACL into the rear interconnection layer BML. The front separation structure 220 may penetrate through and separate the front connection lines 217 as well as the rear connection lines 257.

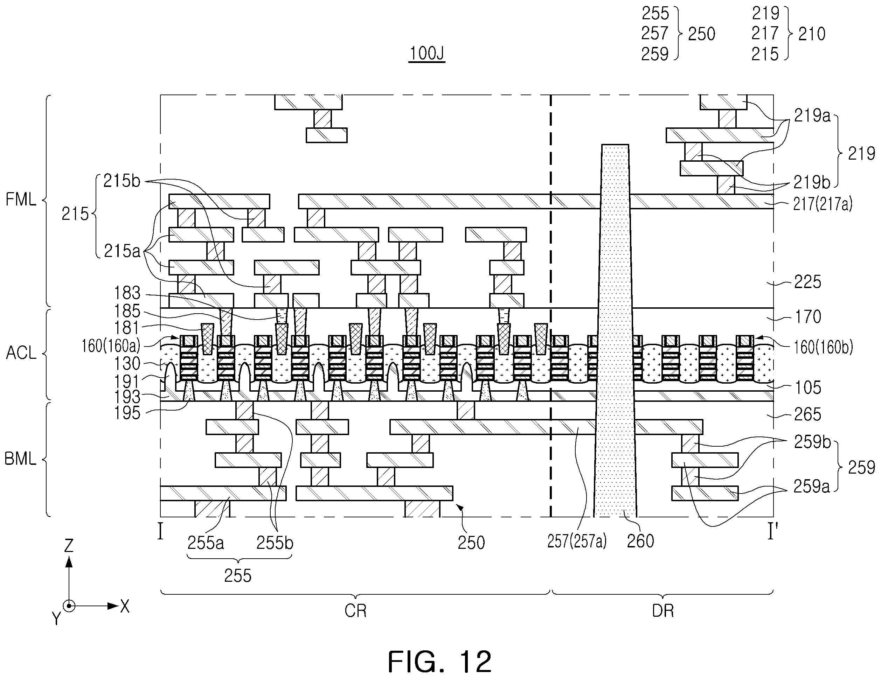

Referring to FIG. 12, unlike the semiconductor device 100I of FIG. 11, a semiconductor device 100J may not include a front separation structure 220 and may be configured so that the rear separation structure 260 may penetrate through the active layer ACL and may extend into the front interconnection layer FML. The rear separation structure 260 may penetrate through and separate the front connection lines 217 as well as the rear connection lines 257.

FIGS. 13A, 14A, 15A, 16A, 17A, 18A, 19A, 20, 21, 22A, 23 and 24 are cross-sectional views illustrating a method of manufacturing a semiconductor device according to example embodiments according to a process sequence. FIGS. 13A, 14A, 15A, 16A, 17A, 18A, 19A, 20, 21, 22A, 23 and 24 illustrate a region corresponding to FIG. 2B.

FIGS. 13B, 14B, 15B, 16B, 17B, 18B, 19B and 22B are partially enlarged views illustrating a method of manufacturing a semiconductor device according to example embodiments according to the process sequence. FIGS. 13B, 14B, 15B, 16B, 17B, 18B, 19B and 22B illustrate regions corresponding to FIG. 2C.

Referring to FIGS. 13A and 13B, a plurality of sacrificial layers 120 and a plurality of channel layers 141, 142 and 143 may be alternately stacked on a substrate 101, and the plurality of channel layers 141, 142 and 143 and the substrate 101 may in some embodiments be partially removed to form an active structure including an active region 105.

The substrate 101 may include silicon (Si), germanium (Ge), or silicon germanium (SiGe). The substrate 101 may include a bulk wafer, an epitaxial layer, a silicon on insulator (SOI) layer, or a semiconductor on insulator (SeOI) layer.

The plurality of channel layers 141, 142 and 143 may include first to third channel layers 141, 142 and 143, and the sacrificial layers 120 may be alternately stacked with the plurality of channel layers such as 141, 142 and 143. The plurality of sacrificial layers 120 may be layers replaced with the gate dielectric layers 162 and the gate electrodes 165 below the channel layers (such as first to third channel layers 141, 142 and 143) through subsequent processes, as illustrated in FIGS. 2B and 2C. The sacrificial layers 120 may be formed of a material having etch selectivity with respect to the channel layers such as the first to third channel layers 141, 142 and 143. The channel layers such as 141, 142 and 143 may include a material different from the sacrificial layers 120. The sacrificial layers 120 and/or the channel layers such as 141, 142 and 143 may include, for example, a semiconductor material including at least one of silicon (Si), silicon germanium (SiGe), and germanium (Ge), but may include different materials, and may or may not include impurities. For example, the sacrificial layers 120 may include silicon germanium (SiGe), and/or the first to third channel layers 141, 142 and 143 may include silicon (Si).

The sacrificial layers 120 and the channel layers such as 141, 142 and 143 may be formed by performing an epitaxial growth process to form a stack structure. The number of layers of the channel layers alternately stacked with the sacrificial layers 120 may vary in example embodiments.

The active structure may include an active region 105, a plurality of sacrificial layers 120, and channel layers such as 141, 142 and 143. The active structure may be formed in a line shape extending in one direction, for example, the X-direction, and may be spaced apart from an adjacent active structure in the Y-direction. Side surfaces of the active structure in the Y-direction are preferably coplanar with each other, and may be disposed on a straight line.

An insulating material may fill in a region from which portions of each of the active region 105, a plurality of sacrificial layers 120, and he channel layers such as channel layers 141, 142 and 143 are removed. A device isolation layer may be formed by removing a portion of the insulating material so that the active region 105 protrudes beyond an upper surface of the removed insulating material. The active region 105 may be formed as a portion of the substrate 101, and may include an epitaxial layer grown from the substrate 101.

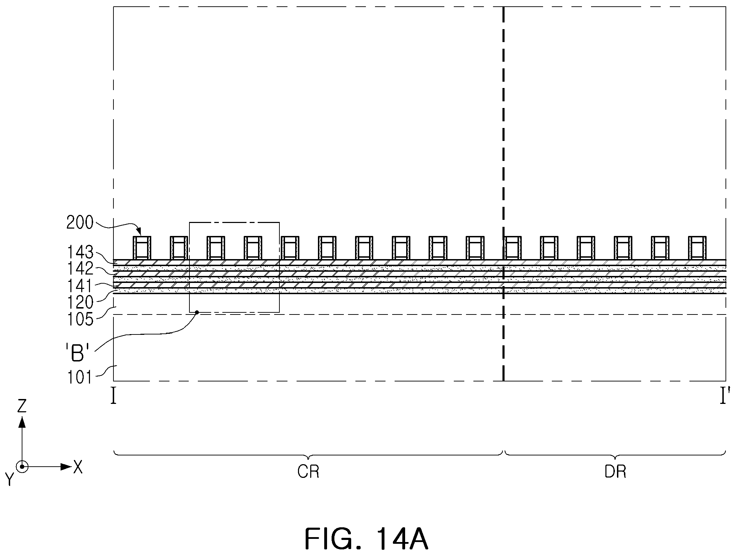

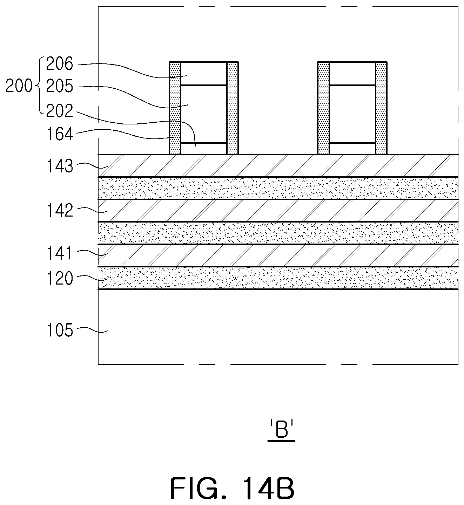

Referring to FIGS. 14A and 14B, sacrificial gate structures 200 and gate spacers 164 may be formed on the active structure.

Each of the sacrificial gate structures 200 may be a sacrificial structure formed in a region in which the gate dielectric layers 162 and the gate electrodes 165 are disposed on the channel structure 140, through subsequent processes, as in FIGS. 2B and 2C. The sacrificial gate structures 200 may have a line shape extending in one direction while intersecting the active structure. The sacrificial gate structures 200 may extend, for example, in the Y-direction. Each of the sacrificial gate structures 200 may include first and second sacrificial gate layers 202 and 205 and a mask pattern layer 206, which are sequentially stacked. The first and second sacrificial gate layers 202 and 205 may be patterned using a mask pattern layer 206.

The first and second sacrificial gate layers 202 and 205 may be an insulating layer and a conductive layer, respectively, but embodiments are not limited thereto, and the first and second sacrificial gate layers 202 and 205 may be formed as a single layer. For example, the first sacrificial gate layer 202 may include silicon oxide, and/or the second sacrificial gate layer 205 may include polysilicon. The mask pattern layer 206 may include silicon oxide and/or silicon nitride.

The gate spacers 164 may be formed on opposite sidewalls of the sacrificial gate structures 200. The first sacrificial gate layer 202 and the second sacrificial gate layer 205 may have the same width, and/or the gate spacers 164 may be formed along a side surface of the first sacrificial gate layer 202 and a side surface of the second sacrificial gate layer 205. Embodiments are not limited thereto. In an embodiment, the first sacrificial gate layer 202 may be formed with a smaller width than the second sacrificial gate layer 205, and/or the gate spacers 164 may be formed along a side surface of the first sacrificial gate layer 202 and a side surface of the second sacrificial gate layer 205. The gate spacers 164 may be formed of a low-κ dielectric material, and may include, for example, at least one of SiO, SiN, SiCN, SiOC, SiON, and SiOCN.

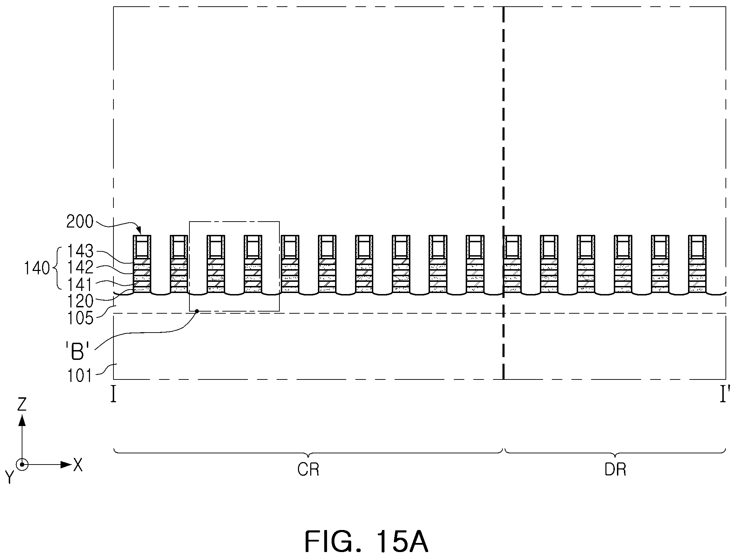

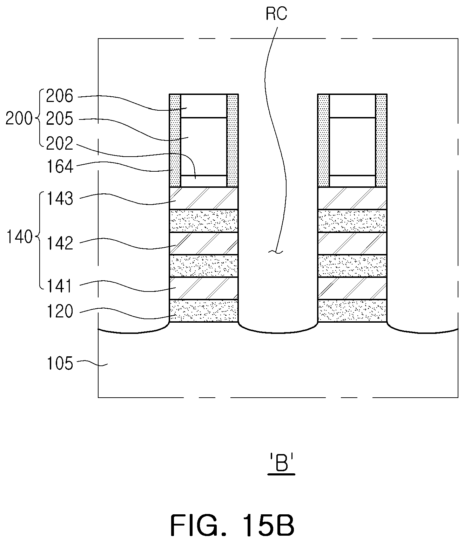

Referring to FIGS. 15A and 15B, an etching process using the sacrificial gate structures 200 as an etching mask may be performed, thereby forming recessed regions RC penetrating through the active structure and exposing the active region 105.

The sacrificial layers 120 and the channel layers such as first to third channel layers 141, 142 and 143 exposed from the sacrificial gate structures 200 may be partially removed to form recessed regions, and/or a plurality of sacrificial layers 120 may be partially removed. Preferably, the channel layers such as layers 141, 142 and 143 may thus form channel structures 140 having a limited length in the X-direction.

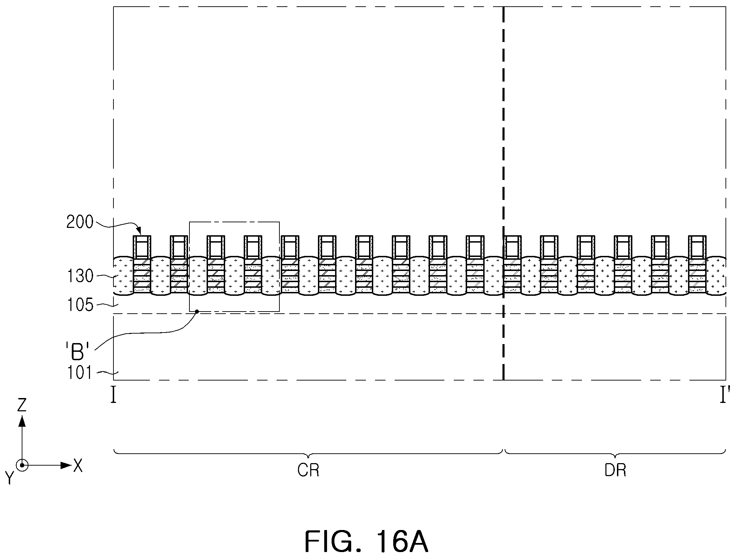

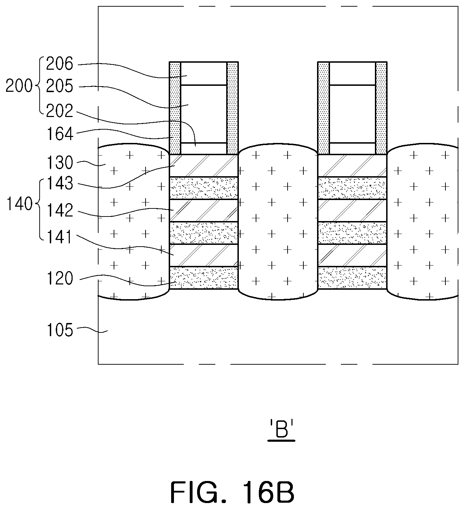

Referring to FIGS. 16A and 16B, a plurality of source/drain regions 130 may be formed in the recessed regions RC.

The source/drain regions 130 may be formed in the recessed regions RC and may be grown and formed from side surfaces of the active regions 105 and the channel structures 140, for example, by a selective epitaxial process.

The source/drain regions 130 may include a plurality of epitaxial layers, and the epitaxial layers may have different non-silicon concentrations. The source/drain regions 130 may include impurities by in-situ doping, and may include a plurality of layers having different doping elements and/or doping concentrations. In some example embodiments, the source/drain regions 130 may have a P-type conductivity and may be formed to include at least one dopant of boron (B), gallium (Ga) and indium (In). In some example embodiments, the source/drain regions 130 may have an N-type conductivity and may be formed to include at least one dopant of phosphorus (P), arsenic (As), and antimony (Sb).

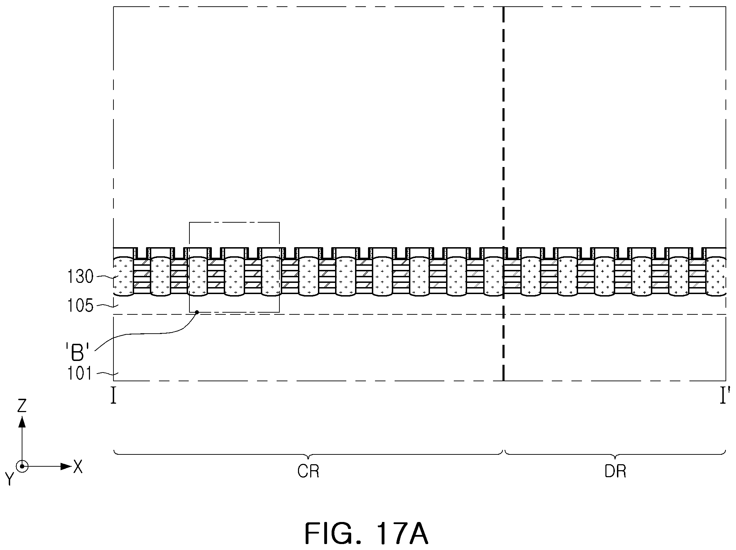

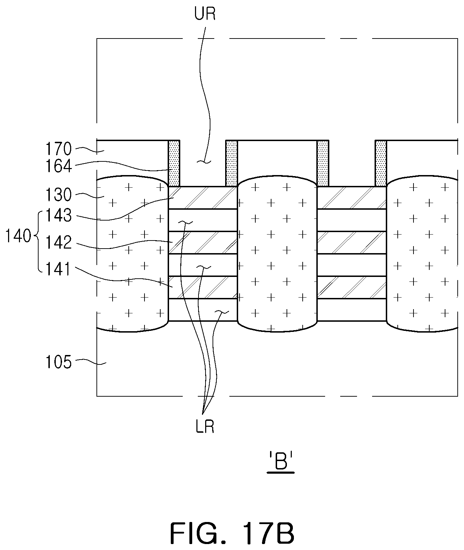

Referring to FIGS. 17A and 17B, the interlayer insulating layer 170 may be partially formed, and/or the sacrificial gate structures 200 and the plurality of sacrificial layers 120 may be removed.

The interlayer insulating layer 170 may be formed by forming an insulating film covering the sacrificial gate structures 200 and the source/drain regions 130 and preferably performing a planarization process.

The sacrificial gate structures 200 and the plurality of sacrificial layers 120 may be selectively removed with respect to the gate spacers 164 and the channel structures 140. First, the sacrificial gate structures 200 may be removed to form upper gap regions UR, and then the sacrificial layers 120 exposed through the upper gap regions UR may be removed to form lower gap regions LR. For example, when the plurality of sacrificial layers 120 include silicon germanium (SiGe) and the channel structures 140 include silicon (Si), the plurality of sacrificial layers 120 may be selectively removed with respect to the channel structures 140 by performing a wet etching process.

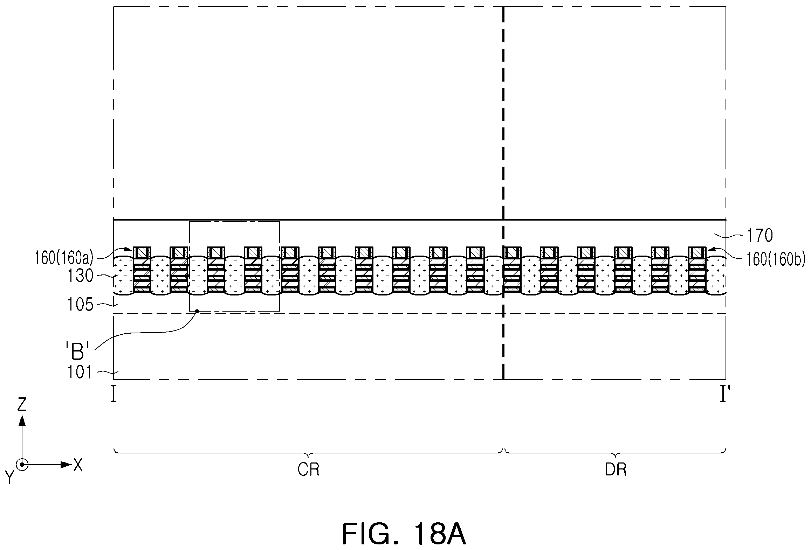

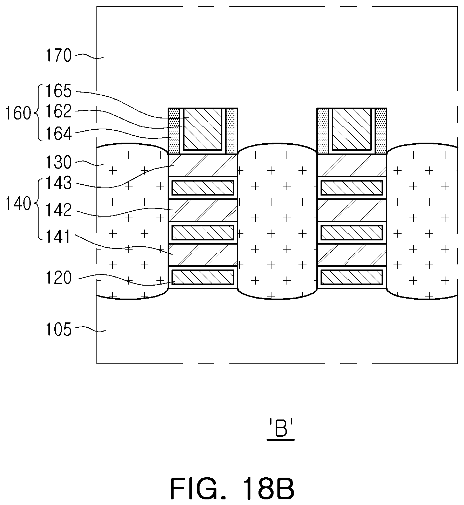

Referring to FIGS. 18A and 18B, gate dielectric layers 162 and gate electrodes 165 may be formed to form gate structures 160.

The gate structures 160 may be formed to fill the upper gap regions UR and the lower gap regions LR. The gate dielectric layers 162 may be formed to conformally cover internal surfaces of the upper gap regions UR and the lower gap regions LR. The gate electrode 165 may be formed to completely fill the upper gap regions UR and the lower gap regions LR, and may then be removed from the upper gap regions UR by a predetermined depth together with the gate dielectric layers 162 and the gate spacers 164. Accordingly, the gate structures 160 respectively including the gate dielectric layers 162 and the gate electrode 165 may be formed.

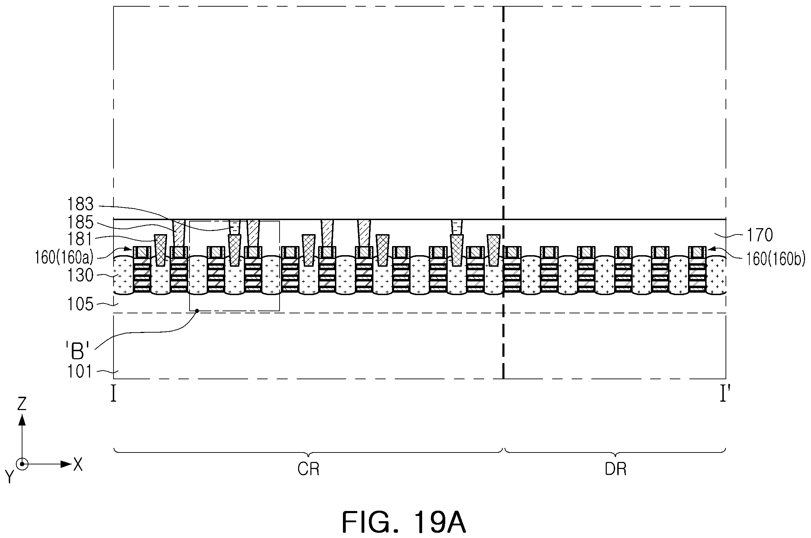

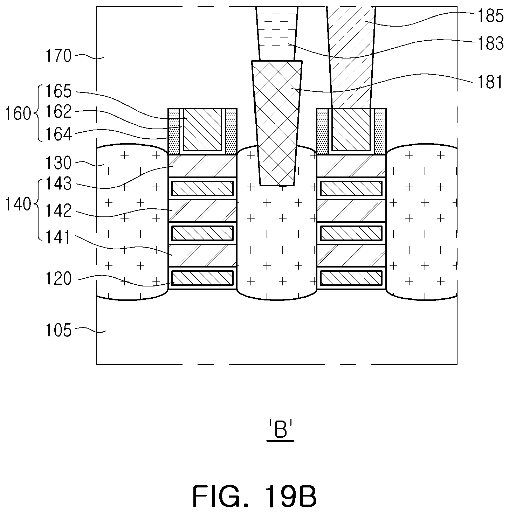

Referring to FIGS. 19A and 19B, front side contacts 181, upper vias 183 and gate contacts 185 may be formed.

The front side contacts 181 may be formed by forming a contact hole penetrating through the interlayer insulating layer 170 and extending to the inside of the source/drain regions 130, and then forming a metal-semiconductor compound layer and a conductive layer.

The gate contacts 185 may be formed on the gate structures 160 through the interlayer insulating layer 170. The gate contacts 185 may be electrically connected to the gate electrodes 165 of the gate structures 160.

The upper vias 183 may be formed on the front side contacts 181 by penetrating through the interlayer insulating layer 170, and may be electrically connected to the front side contacts 181.

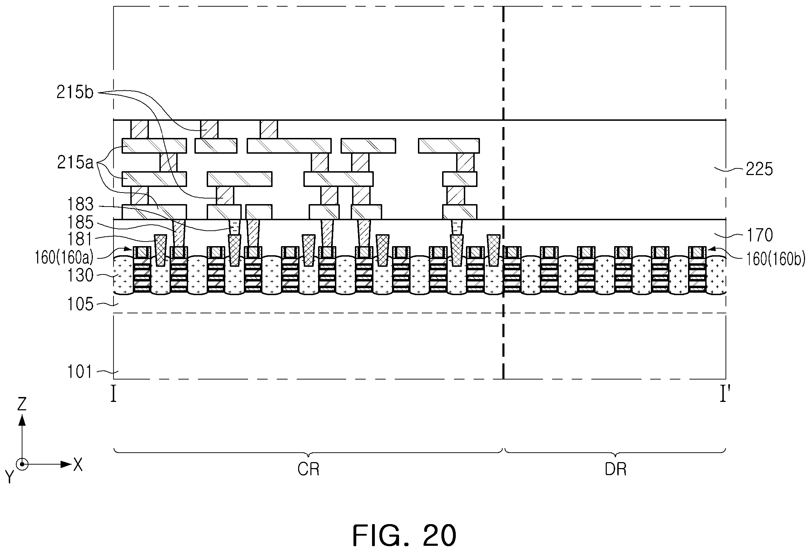

Referring to FIG. 20, front transmission lines 215 and front insulating layers 225 may be partially formed on the interlayer insulating layer 170, the upper vias 183 and/or the gate contacts 185.

The front transmission lines 215 may be formed sequentially from a lower portion, may be formed within the core region CR, and/or may be electrically connected to the upper vias 183 or the gate contacts 185. The front transmission lines 215 may be stacked by alternately forming the first front transmission lines 215a extending in the first direction and the second front transmission lines 215b extending in the second direction. The front insulating layer 225 may be sequentially stacked at the same level as the front transmission lines 215 and/or may be formed of a plurality of layers.

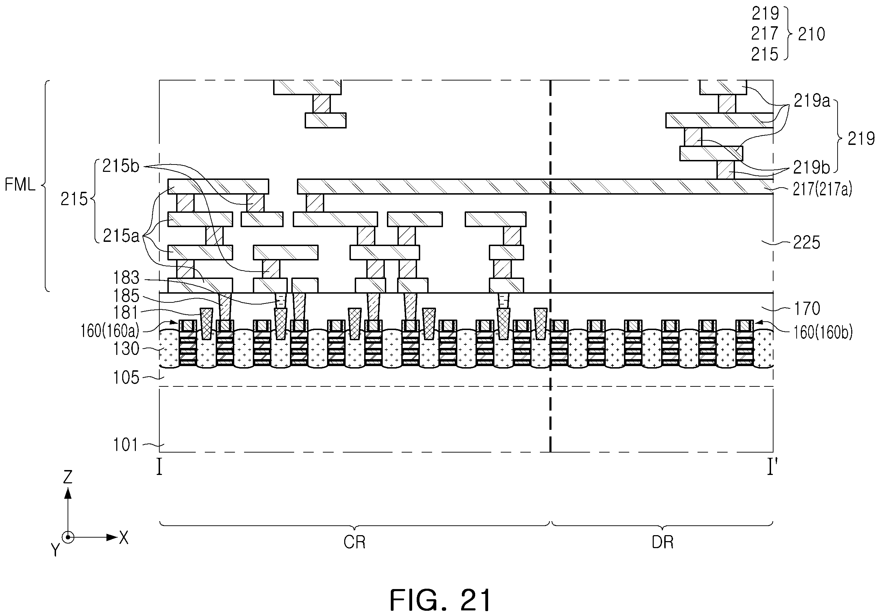

Referring to FIG. 21, the front connection lines 217 and the front inspection lines 219 may be formed to form the front interconnection structure 210, and the front interconnection layer FML may be formed.

The front connection lines 217 may be connected to the front transmission lines 215 within the core region CR, and may extend to the dummy region DR, and the front inspection lines 219 may be formed in the dummy region DR and may be connected to the front transmission lines 215.

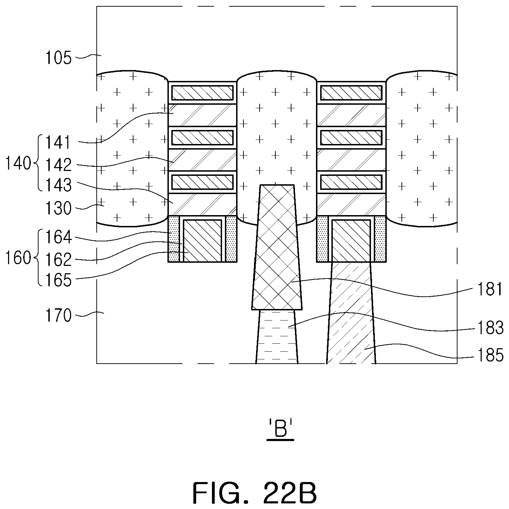

Referring to FIGS. 22A and 22B, at least a portion of the substrate 101 may be removed.

In order to perform a process from a lower surface of the substrate 101 of FIG. 21, a separate carrier substrate may be formed on the front interconnection layer FML and an entire structure may be turned over to perform the following processes. The substrate 101 may be thinned by removing a portion thereof, for example, by a lapping, grinding, and/or polishing process. In some example embodiments, the active region 105 and the device isolation layer may also be partially removed. In some example embodiments, the substrate 101 and the active region 105 may be completely removed.

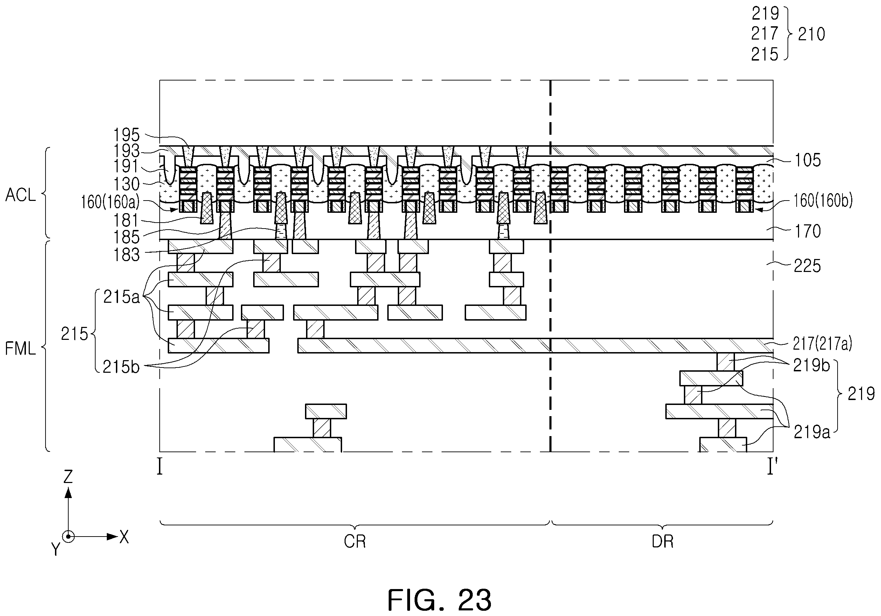

Referring to FIG. 23, the backside contacts 191, the rear power rail 193 and/or the lower blocking structure 195 may be formed as components included in the active layer ACL.

The lower blocking structure 195 penetrating through the active region 105 may be formed, and the backside contacts 191 and the rear power rail 193 may be formed. The lower blocking structure 195 may be formed by forming a hole penetrating through the active region 105 and exposing the gate structures 160, and then depositing an insulating material inside the hole. The backside contacts 191 may be formed by forming a hole penetrating through the active region 105 and partially recessing the source/drain regions 130, and then filling the hole with a conductive material. The backside contacts 191 may be formed in a process identical to or similar to the front side contacts 181. The rear power rail 193 may be formed together with the backside contacts 191, and may be formed by a method such as depositing a conductive material covering the upper surface of the active region 105 based on FIG. 23. Based on FIG. 23, an upper surface of the lower blocking structure 195 and an upper surface of the rear power rail 193 may be formed to form a coplanar surface by a planarization process such as Chemical-Mechanical-Polishing (CMP).

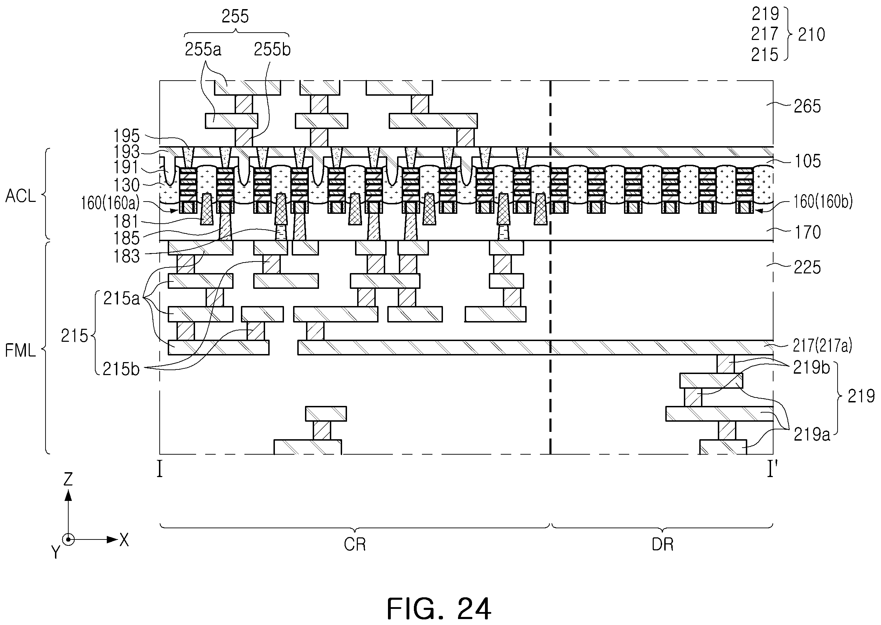

Referring to FIG. 24 together with FIG. 2B, a rear interconnection structure 250 and a rear insulating layer 265 (i.e., a backside insulating layer) may be formed on the rear power rail 193 to form components included in the rear interconnection layer BML.

The rear interconnection structure 250 and the rear insulating layer 265 may be formed in a process identical to or similar to the front interconnection structure 210 and the front insulating layer 225.

Embodiments are set out in the following clauses:
Clause 1: A semiconductor device, comprising:
   an active layer defining a core region, and a dummy region surrounding the core region, the active layer including an active region extending in a first direction, a plurality of gate structures extending in a second direction, intersecting the active region, and a plurality of source/drain regions disposed on side surfaces of the plurality of gate structures on the active region;
   a front interconnection layer disposed on the active layer and including a front interconnection structure and a front insulating layer covering the front interconnection structure; and
   a rear interconnection layer disposed below the active layer and including a rear interconnection structure and a rear insulating layer covering the rear interconnection structure,
   wherein the plurality of gate structures include first gate structures disposed in the core region and electrically connected to the front interconnection structure, and second gate structures disposed in the dummy region and electrically isolated from the front interconnection structure, and
   the front interconnection structure includes front transmission lines disposed in the core region, and front connection lines electrically connected to the front transmission lines and extending from the core region to the dummy region.
Clause 2: The semiconductor device of clause 1, further comprising:
   a front separation structure penetrating through the front connection lines in the dummy region and separating the front connection lines from each other.
Clause 3: The semiconductor device of clause 2,
   wherein the front separation structure extends along an edge of the core region within the dummy region and surrounds at least a portion of the edge of the core region.
Clause 4: The semiconductor device of any preceding clause,
   wherein the rear interconnection structure includes rear transmission lines disposed in the core region, and rear connection lines electrically connected to the rear transmission lines and extending from the core region to the dummy region.
Clause 5: The semiconductor device of clause 4, further comprising:
   a front separation structure extending in a third direction, perpendicular to the first direction and the second direction, and penetrating through the front insulating layer and the active layer,
   wherein the front separation structure penetrates through the front connection lines and the rear connection lines to separate the front connection lines from each other and to separate the rear connection lines from each other.
Clause 6: The semiconductor device of clause 4 or clause 5, further comprising:
   a rear separation structure penetrating through the rear connection lines to separate the rear connection lines from each other.
Clause 7: The semiconductor device of clause 6,
   wherein the rear separation structure extends along an edge of the core region within the dummy region and surrounds at least a portion of the edge of the core region.
Clause 8: The semiconductor device of any one of clauses 4 to 7, further comprising:
   a front separation structure extending in a third direction, perpendicular to the first direction and the second direction, and penetrating through the front connection lines to separate the front connection lines from each other, in the dummy region; and
   a rear separation structure extending in the third direction and penetrating through the rear connection lines to separate the rear connection lines from each other, in the dummy region.
Clause 9: The semiconductor device of clause 8,
   wherein the front separation structure extends to an interior of the active layer by penetrating through the front insulating layer, and
   the rear separation structure extends to the interior of the active layer by penetrating through the rear insulating layer.
Clause 10: The semiconductor device of clause 8 or 9,
   wherein the rear separation structure is in contact with the front separation structure and the active layer.
Clause 11: The semiconductor device of any preceding clause,
   wherein the front transmission lines include first front transmission lines extending in the first direction and second front transmission lines extending in the second direction and alternately stacked with the first front transmission lines, and
   the front connection lines include first front connection lines extending in the first direction on the same level as the first front transmission lines and second front connection lines extending in the second direction on the same level as the second front transmission lines.
Clause 12: The semiconductor device of any preceding clause,
   wherein the active layer includes:
   gate contacts disposed on the first gate structures and electrically connecting the first gate structures and the front interconnection structure;
   an interlayer insulating layer covering the plurality of source/drain regions, the plurality of gate structures and the gate contacts;
   backside contacts penetrating through the active region and disposed to partially recess at least portions of the plurality of source/drain regions from a bottom surface; and
   a rear power rail disposed below the active region and electrically connecting the backside contacts and the rear interconnection structure.
Clause 13: The semiconductor device of any preceding clause,
   wherein source/drain regions disposed in the dummy region, among the plurality of source/drain regions, are electrically isolated from the rear interconnection structure.
Clause 14: A semiconductor device, comprising:
   an active layer including a core region, and a dummy region surrounding the core region;
   transmission lines stacked on the core region in a vertical direction, the transmission lines including first transmission lines extending in a first horizontal direction and second transmission lines alternately stacked with the first transmission lines and extending in a second horizontal direction, intersecting the first horizontal direction;
   inspection lines stacked on the dummy region in the vertical direction, the inspection lines including first inspection lines extending in the first horizontal direction and second inspection lines alternately stacked with the first transmission lines and extending in the second horizontal direction; and
   connection lines extending from the core region to the dummy region and electrically connecting the transmission lines and the inspection lines,
   wherein the connection lines include first connection lines extending in the first horizontal direction and second connection lines extending in the second horizontal direction.
Clause 15: The semiconductor device of clause 14,
   wherein the first connection lines are connected to the second transmission lines on the core region, and
   the second connection lines are connected to the first transmission lines on the core region.
Clause 16: The semiconductor device clause 14,
   wherein the first connection lines are connected to the second inspection lines on the dummy region, and
   the second connection lines are connected to the first inspection lines on the dummy region.
Clause 17: The semiconductor device of any one of clauses 14 to 16, further comprising:
   a separation structure extending along an edge of the core region on the dummy region, and penetrating through the connection lines to separate the connection lines from each other.
Clause 18: A semiconductor device, comprising:
   a plurality of first gate structures spaced apart from each other in a first direction and extending in a second direction, intersecting the first direction;
   a plurality of second gate structures extending in the second direction and spaced apart from each other in the first direction, on one side of the plurality of first gate structures;
   an interlayer insulating layer covering the plurality of first gate structures and the plurality of second gate structures;
   a front interconnection structure disposed on the interlayer insulating layer;
   gate contacts penetrating through the interlayer insulating layer to electrically connect the plurality of first gate structures and the front interconnection structure; and
   a rear interconnection structure disposed below the plurality of first gate structures,
   wherein the front interconnection structure includes:
      front transmission lines, each of the lines including a portion overlapping the plurality of first gate structures in a third direction, perpendicular to the first direction and the second direction;
      front inspection lines, each of the lines including a portion overlapping the plurality of second gate structures in the third direction; and
      front connection lines connecting the front transmission lines and the front inspection lines,
      wherein each of the front connection lines includes a portion overlapping the plurality of first gate structures and a portion overlapping the plurality of second gate structures, in the third direction, and
      the front interconnection structure is electrically isolated from the plurality of second gate structures.
Clause 19: The semiconductor device of clause 18, further comprising:
   a front separation structure extending in the third direction and penetrating through and separating the front connection lines.
Clause 20: The semiconductor device of clause 19,
   wherein the front separation structure is in contact with a portion of the second gate structures.

The present invention is not limited to the above-described embodiments and the accompanying drawings but is defined by the appended claims. Therefore, those of ordinary skill in the art may make various replacements, modifications, or changes without departing from the scope of the present invention as defined by the appended claims, and these replacements, modifications, or changes should be construed as being included in the scope of the present invention.

## Claims

1. A semiconductor device (100) comprising:
an active layer (ACL) including a core region (CR) and a dummy region (DR) surrounding the core region (CR), the active layer (ACL) including an active region (105) extending in a first direction (X) and disposed on both the core region (CR) and the dummy region (DR), a plurality of gate structures (160) disposed on the active region (105), each gate structure of the plurality of gate structures (160) extending in a second direction (Y) and intersecting the active region (105), and a plurality of source/drain regions (130) disposed on side surfaces of the plurality of gate structures (160) and disposed on the active region (105);
a front interconnection layer (FML) disposed on the active layer (ACL) and including a front interconnection structure (210) and a front insulating layer (255) covering the front interconnection structure (210); and
a rear interconnection layer (BML) disposed below the active layer (ACL) and including a rear interconnection structure (250) and a rear insulating layer (265) covering the rear interconnection structure (250),
wherein the plurality of gate structures (160) include a plurality of first gate structures (160a) disposed on the core region (CR) and electrically connected to the front interconnection structure (210), and a plurality of dummy gate structures (160b) disposed on the dummy region (DR) and electrically floated,
wherein the front interconnection structure (210) includes a first front transmission line (215a) disposed on the core region (CR), and a first front connection line (217a) disposed on the dummy region (DR), and
wherein the first front connection line (217a) is electrically connected to the first front transmission line (215a) and extends from the core region (CR) to the dummy region (DR).

2. The semiconductor device (100) of claim 1, further comprising:
a front separation structure (220) disposed on the dummy region (DR) and cutting the first front connection line (217a) into a first front connection line portion connected to the first front transmission line (215a) and a second front connection line portion disconnected from the first front transmission line (215a).

3. The semiconductor device (100) of claim 2,
wherein the front separation structure (220) is disposed on the dummy region (DR), and
wherein, when viewed in a plan view, the front separation structure (220) extends along an outer boundary of the core region (CR) and surrounds at least a portion of the outer boundary of the core region (CR).

4. The semiconductor device (100) of claim 2 or 3,
wherein the front separation structure (220) overlaps in the third direction (Z) and contacts a portion of the plurality of dummy gate structures (160b).

5. The semiconductor device (100) of any preceding claim,
wherein the rear interconnection structure (250) includes a rear transmission line (255) disposed on the core region (CR), and a rear connection line (257) is disposed on the dummy region (DR), and
wherein the rear connection line (257) is electrically connected to the rear transmission line (255) and extends from the core region (CR) to the dummy region (DR).

6. The semiconductor device (100) of claim 5, further comprising:
a front separation structure (220) extending in a third direction (Z), perpendicular to the first direction (X) and the second direction (Y), and penetrating through the front insulating layer (255) and the active layer (ACL),
wherein the front separation structure (220) cuts the first front connection line (217a) into a first front connection line portion connected to the first front transmission line (215a) and a second front connection line portion disconnected from the first front transmission line (215a), and
wherein the front separation structure (220) further cuts the rear connection line (257) into a first rear connection line portion connected to the rear transmission line (255) and a second rear connection line portion disconnected from the rear transmission line (255).

7. The semiconductor device (100) of claim 5 or 6, further comprising:
a rear separation structure (250) cutting the rear connection line (257) into a first rear connection line portion connected to the rear transmission line (255) and a second rear connection line portion disconnected from the rear transmission line (255).

8. The semiconductor device (100) of claim 7,
wherein the rear separation structure (250) is disposed on the dummy region (DR), and
wherein, when viewed in a plan view, the rear separation structure (250) extends along an outer boundary of the core region (CR) and surrounds at least a portion of the outer boundary of the core region (CR).

9. The semiconductor device (100) of claim 7 or 8,
wherein the rear separation structure (250) overlaps in the third direction (Z) and contacts a portion of the plurality of dummy gate structures (160b).

10. The semiconductor device (100) of any one of claims 5 to 9, further comprising:
a front separation structure (220) extending in a third direction (Z), perpendicular to the first direction (X) and the second direction (Y), and cutting the first front connection line (217a) into a first front connection line portion connected to the first front transmission line (215a) and a second front connection line portion disconnected from the first front transmission line (215a); and
a rear separation structure (250) extending in the third direction (Z) and cutting the rear connection line (257) into a first rear connection line portion connected to the rear transmission line (255) and a second rear connection line portion disconnected from the rear transmission line (255).

11. The semiconductor device (100) of claim 10,
wherein the front separation structure (220) extends to an interior of the active layer (ACL) by penetrating through the front insulating layer (255), and
wherein the rear separation structure (250) extends to the interior of the active layer (ACL) by penetrating through the rear insulating layer (265).

12. The semiconductor device (100) of claim 10 or 11,
wherein the rear separation structure (250) contacts the front separation structure (220) and the active layer (ACL).

13. The semiconductor device (100) of any preceding claim,
wherein the front interconnection structure (210) further includes:
a second front transmission line (215b) extending in the second direction (Y) and disposed below the first front transmission line (215a) extending in the first direction (X); and
a second front connection line (217b) extending in the second direction (Y),
wherein the first front connection line (217a) extending in the first direction (X) is disposed at the same level as the first front transmission line (215a), and
wherein the second front connection line (217b) extending in the second direction (Y) is disposed at the same level as the second front transmission line (215b).

14. The semiconductor device (100) of any preceding claim,
wherein the active layer (ACL) includes:
a plurality of gate contacts (185) disposed on the plurality of first gate structures (160a) and electrically connecting the plurality of first gate structures (160a) to the front interconnection structure (210);
an interlayer insulating layer (170) covering the plurality of source/drain regions (130), the plurality of gate structures (160), and the plurality of gate contacts (185);
a plurality of backside contacts (191) penetrating through the active region (105) from a bottom surface of the active region (105) and extending into a plurality of first source/drain regions, which is disposed on the core region (CR) and is among the plurality of source/drain regions (130); and
a rear power rail (193) disposed below the active region (105) and electrically connecting the plurality of backside contacts (191) to the rear interconnection structure (250).

15. The semiconductor device (100) of any preceding claim,
wherein a plurality of second source/drain regions, disposed in the dummy region (DR), among the plurality of source/drain regions (130), are electrically floated.

## Amended claims

### Amended claims in accordance with Rule 137(2) EPC.

1. A semiconductor device (100) comprising:
an active layer (ACL) including a core region (CR) and a dummy region (DR) surrounding the core region (CR), the active layer (ACL) including an active region (105) extending in a first direction (X) and disposed on both the core region (CR) and the dummy region (DR), a plurality of gate structures (160) disposed on the active region (105), each gate structure of the plurality of gate structures (160) extending in a second direction (Y) and intersecting the active region (105), and a plurality of source/drain regions (130) disposed on side surfaces of the plurality of gate structures (160) and disposed on the active region (105);
a front interconnection layer (FML) disposed on the active layer (ACL) and including a front interconnection structure (210) and a front insulating layer (225) covering the front interconnection structure (210); and
a rear interconnection layer (BML) disposed below the active layer (ACL) and including a rear interconnection structure (250) and a rear insulating layer (265) covering the rear interconnection structure (250),
wherein the plurality of gate structures (160) include a plurality of first gate structures (160a) disposed on the core region (CR) and electrically connected to the front interconnection structure (210), and a plurality of dummy gate structures (160b) disposed on the dummy region (DR) and electrically floated,
wherein the front interconnection structure (210) includes a first front transmission line (215a) disposed on the core region (CR), and a first front connection line (217a) disposed on the dummy region (DR),
wherein the first front connection line (217a) is electrically connected to the first front transmission line (215a) and extends from the core region (CR) to the dummy region (DR), and
wherein the dummy region (DR) comprises a front inspection line (219) that is electrically connected to the first front transmission line (215a) via the first front connection line (217a).

2. The semiconductor device (100) of claim 1, further comprising:
a front separation structure (220) disposed on the dummy region (DR) and cutting the first front connection line (217a) into a first front connection line portion connected to the first front transmission line (215a) and a second front connection line portion disconnected from the first front transmission line (215a).

3. The semiconductor device (100) of claim 2,
wherein the front separation structure (220) is disposed on the dummy region (DR), and
wherein, when viewed in a plan view, the front separation structure (220) extends along an outer boundary of the core region (CR) and surrounds at least a portion of the outer boundary of the core region (CR).

4. The semiconductor device (100) of claim 2 or 3,
wherein the front separation structure (220) overlaps in the third direction (Z) and contacts a portion of the plurality of dummy gate structures (160b).

5. The semiconductor device (100) of any preceding claim,
wherein the rear interconnection structure (250) includes a rear transmission line (255) disposed on the core region (CR), and a rear connection line (257) is disposed on the dummy region (DR), and
wherein the rear connection line (257) is electrically connected to the rear transmission line (255) and extends from the core region (CR) to the dummy region (DR).

6. The semiconductor device (100) of claim 5, further comprising:
a front separation structure (220) extending in a third direction (Z), perpendicular to the first direction (X) and the second direction (Y), and penetrating through the front insulating layer (225) and the active layer (ACL),
wherein the front separation structure (220) cuts the first front connection line (217a) into a first front connection line portion connected to the first front transmission line (215a) and a second front connection line portion disconnected from the first front transmission line (215a), and
wherein the front separation structure (220) further cuts the rear connection line (257) into a first rear connection line portion connected to the rear transmission line (255) and a second rear connection line portion disconnected from the rear transmission line (255).

7. The semiconductor device (100) of claim 5 or 6, further comprising:
a rear separation structure (260) cutting the rear connection line (257) into a first rear connection line portion connected to the rear transmission line (255) and a second rear connection line portion disconnected from the rear transmission line (255).

8. The semiconductor device (100) of claim 7,
wherein the rear separation structure (260) is disposed on the dummy region (DR), and
wherein, when viewed in a plan view, the rear separation structure (260) extends along an outer boundary of the core region (CR) and surrounds at least a portion of the outer boundary of the core region (CR).

9. The semiconductor device (100) of claim 7 or 8,
wherein the rear separation structure (260) overlaps in the third direction (Z) and contacts a portion of the plurality of dummy gate structures (160b).

10. The semiconductor device (100) of any one of claims 5 to 9, further comprising:
a front separation structure (220) extending in a third direction (Z), perpendicular to the first direction (X) and the second direction (Y), and cutting the first front connection line (217a) into a first front connection line portion connected to the first front transmission line (215a) and a second front connection line portion disconnected from the first front transmission line (215a); and
a rear separation structure (260) extending in the third direction (Z) and cutting the rear connection line (257) into a first rear connection line portion connected to the rear transmission line (255) and a second rear connection line portion disconnected from the rear transmission line (255).

11. The semiconductor device (100) of claim 10,
wherein the front separation structure (220) extends to an interior of the active layer (ACL) by penetrating through the front insulating layer (225), and
wherein the rear separation structure (260) extends to the interior of the active layer (ACL) by penetrating through the rear insulating layer (265).

12. The semiconductor device (100) of claim 10 or 11,
wherein the rear separation structure (260) contacts the front separation structure (220) and the active layer (ACL).

13. The semiconductor device (100) of any preceding claim,
wherein the front interconnection structure (210) further includes:
a second front transmission line (215b) extending in the second direction (Y) and disposed below the first front transmission line (215a) extending in the first direction (X); and
a second front connection line (217b) extending in the second direction (Y),
wherein the first front connection line (217a) extending in the first direction (X) is disposed at the same level as the first front transmission line (215a), and
wherein the second front connection line (217b) extending in the second direction (Y) is disposed at the same level as the second front transmission line (215b).

14. The semiconductor device (100) of any preceding claim,
wherein the active layer (ACL) includes:
a plurality of gate contacts (185) disposed on the plurality of first gate structures (160a) and electrically connecting the plurality of first gate structures (160a) to the front interconnection structure (210);
an interlayer insulating layer (170) covering the plurality of source/drain regions (130), the plurality of gate structures (160), and the plurality of gate contacts (185);
a plurality of backside contacts (191) penetrating through the active region (105) from a bottom surface of the active region (105) and extending into a plurality of first source/drain regions, which is disposed on the core region (CR) and is among the plurality of source/drain regions (130); and
a rear power rail (193) disposed below the active region (105) and electrically connecting the plurality of backside contacts (191) to the rear interconnection structure (250).

15. The semiconductor device (100) of any preceding claim,
wherein a plurality of second source/drain regions, disposed in the dummy region (DR), among the plurality of source/drain regions (130), are electrically floated.
